# EUROPEAN PATENT APPLICATION

(11) **EP 4 618 712 A1**
(43) Date of publication of application: **17.09.2025**
(21) Application number: 24208864.9
(22) Date of filing: 25.10.2024
(51) Int. Cl.: H10B 41/50, H10B 43/10, H10B 43/50

(54) **SEMICONDUCTOR DEVICES HAVING TRENCH-BASED GUARD BANDS AND ELECTRONIC SYSTEMS INCLUDING THE SAME**

(30) Priority: 13.03.2024 KR 20240035088
(71) Applicant: Samsung Electronics Co., Ltd., Suwon-si, Gyeonggi-do 16677 (KR)
(72) Inventor: LEE, Sea Hoon, 16677 Suwon-si (KR); LIM, Junhee, 16677 Suwon-si (KR); CHANG, Seongpil, 16677 Suwon-si (KR)
(74) Representative: Marks & Clerk LLP

(57) **Abstract**

A semiconductor device includes a substrate having at least one device isolation layer embedded therein, which defines a dummy active pattern and a plurality of active patterns in the substrate. A guard band extends in the substrate and surrounds the dummy active pattern and the plurality of active patterns. A dummy transistor has a plurality of dummy source/drain regions in the dummy active pattern, and a plurality of pass transistors have source/drain regions in the plurality of active patterns. Dummy wiring lines are provided, which electrically connect the guard band to the dummy source/drain regions of the dummy transistor. A field doping region, which at least partially overlaps with the device isolation layer, has an impurity therein that extends into the substrate.

## Description

### BACKGROUND

The present inventive concepts relate to semiconductor devices and electronic systems including the same.

It is typically necessary to have a semiconductor device capable of storing a large amount of data in an electronic system which requires data storage. A semiconductor device has been highly integrated to meet high performance and low manufacturing cost which are required by customers. Integration of typical two-dimensional or planar semiconductor devices is primarily determined by the area occupied by a unit memory cell, such that it is greatly influenced by the level of technology for forming fine patterns. However, the extremely expensive processing equipment needed to increase pattern fineness may set a practical limitation on increasing the integration of the two-dimensional or planar semiconductor devices. Therefore, there have been proposed three-dimensional semiconductor memory devices having three-dimensionally arranged memory cells.

### SUMMARY

Some embodiments of the present inventive concepts provide a semiconductor device whose reliability is improved.

Some embodiments of the present inventive concepts provide an electronic system including a semiconductor device whose reliability is improved.

The object of the present inventive concepts is not limited to those mentioned above, and other objects which have not been mentioned above will be clearly understood to those skilled in the art from the following description.

According to some embodiments of the present inventive concepts, a semiconductor device may include a device isolation layer, which extends in a substrate and defines a dummy active pattern and a plurality of active patterns, and a guard band, which extends in the substrate and surrounds the dummy active pattern and the active patterns, and is adjacent to the dummy active pattern. A dummy transistor is provided on the dummy active pattern and includes a plurality of dummy source/drain regions. A plurality of pass transistors are provided on the active patterns. A plurality of dummy wiring lines are provided, which electrically connect the guard band to the dummy source/drain regions of the dummy transistor. A field doping region is provided, which includes impurities in the substrate; the field doping region may overlap the device isolation layer.

According to some embodiments of the present inventive concepts, a semiconductor device may include a dummy active pattern, a guard band active pattern, and a plurality of active patterns on a substrate, along with a device isolation layer that defines the dummy active pattern, the guard band active pattern, and the active patterns. A plurality of pass transistors are provided on the active patterns. A field doping region, which is provided in the substrate and doped with an impurity, overlaps the device isolation layer. A plurality of dummy source/drain regions are provided on the dummy active pattern, and have a first conductivity type. A guard doping region is provided on the guard band active pattern, and has the first conductivity type. A plurality of gate electrodes are provided on the dummy active pattern and between the dummy source/drain regions; each of the gate electrodes extends onto the active patterns. An interlayer dielectric layer is provided that covers the gate electrodes, the dummy source/drain regions, the pass transistors, and the guard doping region. A plurality of dummy active contacts are provided, which penetrate the interlayer dielectric layer to come into electrical connection with the dummy source/drain regions. A guard active contact is provided, which penetrates the interlayer dielectric layer to come into electrical connection with the guard doping region. A plurality of dummy metal lines are provided that electrically connect the dummy active contacts to the guard active contact.

According to some embodiments of the present inventive concepts, an electronic system may include a semiconductor device that includes an input/output pad electrically connected to a peripheral circuit, and a controller electrically connected through the input/output pad to the semiconductor device. The semiconductor device may include a device isolation layer, which extends in a substrate and defines a dummy active pattern and a plurality of active patterns. A guard band is provided in the substrate, and surrounds dummy active pattern and the active patterns. A dummy transistor is provided on the dummy active pattern and includes a plurality of dummy source/drain regions. A plurality of pass transistors are provided on the active patterns. A plurality of dummy wiring lines are provided, which electrically connect the guard band to the dummy source/drain regions of the dummy transistor. A field doping region is provided, and includes an impurity doped into the substrate; the field doping region may overlap the device isolation layer.

At least some of the above and other features of the invention are set out in the claims.

### BRIEF DESCRIPTION OF DRAWINGS

FIG. 1A illustrates a simplified schematic diagram showing an electronic system that includes a semiconductor device according to some embodiments of the present inventive concepts.
FIG. 1B illustrates a simplified perspective view showing an electronic system including a semiconductor device according to some embodiments of the present inventive concepts.
FIG. 1C illustrates a cross-sectional view taken along line I-I' of FIG. 1B, showing a semiconductor package that includes a semiconductor device according to some embodiments of the present inventive concepts.
FIG. 1D illustrates a cross-sectional view taken along line I-I' of FIG. 1B, showing a semiconductor package that includes a semiconductor device according to some embodiments of the present inventive concepts.
FIG. 2 illustrates a simplified block diagram showing a memory cell array of a semiconductor device according to some embodiments of the present inventive concepts.
FIG. 3 illustrates a simplified block diagram showing a semiconductor device according to some embodiments of the present inventive concepts.
FIG. 4A illustrates an enlarged view of section AA of FIG. 3, showing a semiconductor device according to some embodiments of the present inventive concepts.
FIG. 4B illustrates a cross-sectional view taken along line A-A' of FIG. 4A.
FIG. 4C illustrates a cross-sectional view taken along line B-B' of FIG. 4A.
FIG. 4D illustrates a cross-sectional view taken along line C-C' of FIG. 4A.
FIG. 5A illustrates an enlarged cross-sectional view of section AA of FIG. 3, showing a semiconductor device according to some embodiments of the present inventive concepts.
FIG. 5B illustrates a cross-sectional view taken along line A-A' of FIG. 5A.
FIG. 5C illustrates a cross-sectional view taken along line B-B' of FIG. 5A.
FIG. 5D illustrates a cross-sectional view taken along line C-C' of FIG. 5A.
FIG. 6A illustrates an enlarged cross-sectional view of section AA of FIG. 3, showing a semiconductor device according to some embodiments of the present inventive concepts.
FIG. 6B illustrates a cross-sectional view taken along line A-A' of FIG. 6A.
FIG. 6C illustrates a cross-sectional view taken along line B-B' of FIG. 6A.
FIG. 6D illustrates a cross-sectional view taken along line C-C' of FIG. 6A.
FIG. 7A illustrates an enlarged cross-sectional view of section AA of FIG. 3, showing a semiconductor device according to some embodiments of the present inventive concepts.
FIG. 7B illustrates a cross-sectional view taken along line A-A' of FIG. 7A.
FIG. 7C illustrates a cross-sectional view taken along line B-B' of FIG. 7A.
FIG. 7D illustrates a cross-sectional view taken along line C-C' of FIG. 7A.
FIG. 8A illustrates an enlarged cross-sectional view of section AA of FIG. 3, showing a semiconductor device according to some embodiments of the present inventive concepts.
FIG. 8B illustrates a cross-sectional view taken along line A-A' of FIG. 8A.
FIG. 8C illustrates a cross-sectional view taken along line B-B' of FIG. 8A.
FIG. 8D illustrates a cross-sectional view taken along line C-C' of FIG. 8A.
FIG. 9A illustrates an enlarged cross-sectional view of section AA of FIG. 3, showing a semiconductor device according to some embodiments of the present inventive concepts.
FIG. 9B illustrates a cross-sectional view taken along line A-A' of FIG. 9A.
FIG. 9C illustrates a cross-sectional view taken along line B-B' of FIG. 9A.
FIG. 9D illustrates a cross-sectional view taken along line C-C' of FIG. 9A.
FIG. 10A illustrates an enlarged cross-sectional view of section AA of FIG. 3, showing a semiconductor device according to some embodiments of the present inventive concepts.
FIG. 10B illustrates a cross-sectional view taken along line A-A' of FIG. 10A.
FIG. 10C illustrates a cross-sectional view taken along line B-B' of FIG. 10A.
FIG. 10D illustrates a cross-sectional view taken along line C-C' of FIG. 10A.
FIG. 11A illustrates an enlarged cross-sectional view of section AA of FIG. 3, showing a semiconductor device according to some embodiments of the present inventive concepts.
FIG. 11B illustrates a cross-sectional view taken along line A-A' of FIG. 11A.
FIG. 11C illustrates a cross-sectional view taken along line B-B' of FIG. 11A.
FIG. 11D illustrates a cross-sectional view taken along line C-C' of FIG. 11A.
FIG. 12A illustrates an enlarged cross-sectional view of section AA of FIG. 3, showing a semiconductor device according to some embodiments of the present inventive concepts.
FIG. 12B illustrates a cross-sectional view taken along line A-A' of FIG. 12A.
FIG. 12C illustrates a cross-sectional view taken along line B-B' of FIG. 12A.
FIG. 12D illustrates a cross-sectional view taken along line C-C' of FIG. 12A.
FIG. 13 illustrates a cross-sectional view partially showing a memory cell array of a semiconductor device according to some embodiments of the present inventive concepts.

### DETAILED DESCRIPTION OF EMBODIMENTS

With reference to drawings, the following will describe in detail a semiconductor device and an electronic system including the same according to some embodiments of the present inventive concepts.

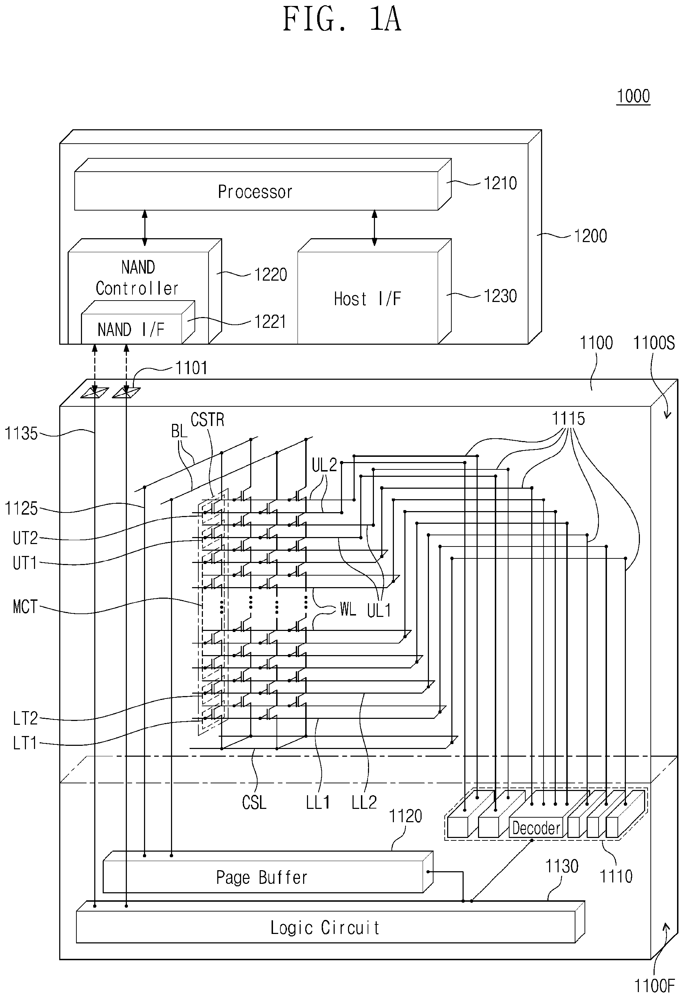

FIG. 1A illustrates a simplified schematic diagram showing an electronic system that includes a semiconductor device according to some embodiments of the present inventive concepts. Referring to FIG. 1A, an electronic system 1000 according to some embodiments of the present inventive concepts may include a semiconductor device 1100 and a controller 1200 electrically connected to the semiconductor device 1100. The electronic system 1000 may be a storage device that includes a single or a plurality of semiconductor devices 1100, or may be an electronic device that includes the storage device. For example, the electronic system 1000 may be a solid state drive (SSD) device, a universal serial bus (USB), a computing system, a medical apparatus, or a communication apparatus, each of which includes a single or a plurality of semiconductor devices 1100.

The semiconductor device 1100 may be a nonvolatile memory device, such as a NAND Flash memory device. The semiconductor device 1100 may include a first structure 1100F and a second structure 11005 on the first structure 1100F. In some embodiments, the first structure 1100F may be disposed on a side of the second structure 1 1005. The first structure 1100F may be a peripheral circuit structure that includes a decoder circuit 1110, a page buffer 1120, and a logic circuit 1130. The second structure 11005 may be a memory cell structure that includes bit lines BL, a common source line CSL, word lines WL, first and second gate upper lines UL1 and UL2, first and second gate lower lines LL1 and LL2, and memory cell strings CSTR between the bit line BL and the common source line CSL.

In the second structure 1 100S, each of the memory cell strings CSTR may include lower transistors LT1 and LT2 adjacent to the common source line CSL, upper transistors UT1 and UT2 adjacent to the bit line BL, and a plurality of memory cells MCT disposed between the lower transistors LT1 and LT2 and the upper transistors UT1 and UT2. The number of the lower transistors LT1 and LT2 and of the upper transistors UT1 and UT2 may be variously changed in accordance with embodiments.

In some embodiments, the upper transistors UT1 and UT2 may include a string selection transistor, and the lower transistors LT1 and LT2 may include a ground selection transistor. The gate lower lines LL1 and LL2 may be gate electrodes of the lower transistors LT1 and LT2, respectively. The word lines WL may be gate electrodes of the memory cells MCT, and the gate upper lines UL1 and UL2 may be gate electrodes of the upper transistors UT1 and UT2, respectively. The memory cells MCT of each memory cell string CSTR may be controlled by a back gate line.

The common source line CSL, the first and second gate lower lines LL1 and LL2, the word lines WL, and the first and second gate upper lines UL1 and UL2 may be electrically connected to the decoder circuit 1110 through first connection lines 1115 that extend from the first structure 1100F toward the second structure 11005. The bit lines BL may be electrically connected to the page buffer 1120 through second connection lines 1125 that extend from the first structure 1100F to the second structure 11005.

In the first structure 1100F, the decoder circuit 1110 and the page buffer 1120 may perform a control operation to at least one selection memory cell transistor among the plurality of memory cell transistors MCT. The logic circuit 1130 may control the decoder circuit 1110 and the page buffer 1120. The semiconductor device 1100 may communicate with the controller 1200 through an input/output pad 1101 electrically connected to the logic circuit 1130. The input/output pad 1101 may be electrically connected to the logic circuit 1130 through an input/output connection line 1135 that extends from the first structure 1100F to the second structure 1100S.

Although not shown, the first structure 1100F may include a voltage generator. The voltage generator may produce program voltages, read voltages, pass voltages, and verification voltages that are required for operating the memory cell strings CSTR. The program voltage may be relatively higher (e.g., about 20 V to about 40 V) than the read voltage, the pass voltage, and the verification voltage.

In some embodiments, the first structure 1100F may include high-voltage transistors and low-voltage transistors. The decoder circuit 1110 may include pass transistors connected to the word lines WL of the memory cell strings CSTR. The pass transistors may include high-voltage transistors capable of withstanding high voltages, such as program voltages applied to the word lines WL in a program operation. The page buffer 1120 may also include high-voltage transistors capable of withstanding high voltages.

The controller 1200 may include a processor 1210, a NAND controller 1220, and a host interface 1230. According to some embodiments, the electronic system 1000 may include a plurality of semiconductor devices 1100, and in this case, the controller 1200 may control the plurality of semiconductor devices 1100. The processor 1210 may control an overall operation of the electronic system 1000 that includes the controller 1200. The processor 1210 may operate based on predetermined firmware, and may control the NAND controller 1220 to access the semiconductor device 1100. The NAND controller 1220 may include a NAND interface 1221 that processes communication with the semiconductor device 1100. The NAND interface 1221 may be used to transfer therethrough a control command to control the semiconductor device 1100, data intended to be written on the memory cell transistors MCT of the semiconductor device 1100, and/or data intended to be read from the memory cell transistors MCT of the semiconductor device 1100. The host interface 1230 may provide the electronic system 1000 with communication with an external host. When a control command is received through the host interface 1230 from an external host, the semiconductor device 1100 may be controlled by the processor 1210 in response to the control command.

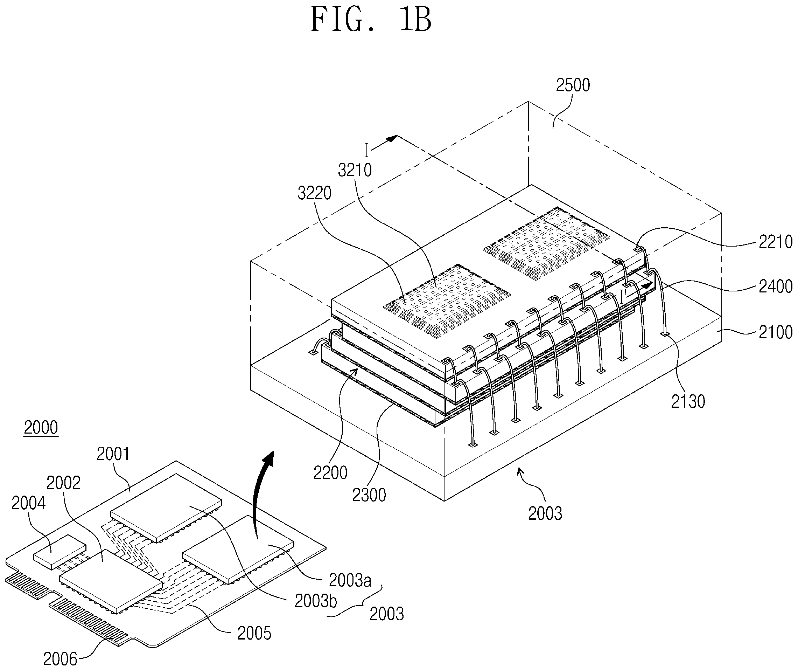

FIG. 1B illustrates a simplified perspective view showing an electronic system that includes a semiconductor device according to some embodiments of the present inventive concepts. Referring to FIG. 1B, an electronic system 2000 according to some embodiments of the present inventive concepts may include a main board 2001, a controller 2002 mounted on the main board 2001, at least one semiconductor package 2003, and a dynamic random access memory (DRAM) 2004. The semiconductor package 2003 and the DRAM 2004 may be connected to the controller 2002 through wiring patterns 2005 formed on the main board 2001.

The main board 2001 may include a connector 2006 including a plurality of pins that are coupled to an external host. The number and arrangement of the plurality of pins in the connector 2006 may be changed based on a communication interface between the electronic system 2000 and the external host. In some embodiments, the electronic system 2000 may communicate with the external host through one or more interfaces, for example, universal serial bus (USB), peripheral component interconnect express (PIC-Express), serial advanced technology attachment (SATA), and M-PHY for universal flash storage (UFS). In some embodiments, the electronic system 2000 may operate with power supplied through the connector 2006 from the external host. The electronic system 2000 may further include a power management integrated circuit (PMIC) by which the power supplied from the external host is distributed to the controller 2002 and the semiconductor package 2003. The controller 2002 may write data to the semiconductor package 2003, may read data from the semiconductor package 2003, or may increase an operating speed of the electronic system 2000.

The DRAM 2004 may be a buffer memory that reduces a difference in speed between the external host and the semiconductor package 2003 that serves as a data storage space. The DRAM 2004 included in the electronic system 2000 may operate as a kind of cache memory, and may provide a space for temporary data storage in a control operation of the semiconductor package 2003. When the DRAM 2004 is included in the electronic system 2000, the controller 2002 may include not only a NAND controller for controlling the semiconductor package 2003, but also a DRAM controller for controlling the DRAM 2004.

The semiconductor package 2003 may include first and second semiconductor packages 2003a and 2003b that are spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, semiconductor chips 2200 on the package substrate 2100, adhesion layers 2300 disposed on bottom surfaces of the semiconductor chips 2200, connection structures 2400 that electrically connect the semiconductor chips 2200 to the package substrate 2100, and a molding layer 2500 that lies on the package substrate 2100 and covers the semiconductor chips 2200 and the connection structures 2400.

The package substrate 2100 may be a printed circuit board including upper pads 2130. Each of the semiconductor chips 2200 may include one or more input/output pads 2210. The input/output pad 2210 may correspond to the input/output pad 1101 of FIG. 1A. Each of the semiconductor chips 2200 may include stack structures 3210 and vertical structures 3220. Each of the semiconductor chips 2200 may include a semiconductor device which will be discussed below according to some embodiments of the present inventive concepts.

In some embodiments, the connection structure 2400 may be a bonding wire that electrically connects the input/output pad 2210 to the upper pad 2130. Therefore, in each of the first and second semiconductor packages 2003a and 2003b, the semiconductor chips 2200 may be electrically connected to each other in a bonding wire manner, and may be electrically connected to the upper pads 2130 of the package substrate 2100. In some embodiments, in each of the first and second semiconductor packages 2003a and 2003b, the semiconductor chips 2200 may be electrically connected to each other through connection structures such as through silicon vias (TSV) instead of the connection structures 2400 shaped like bonding wires.

In some embodiments, the controller 2002 and the semiconductor chips 2200 may be included in a single package. For example, the controller 2002 and the semiconductor chips 2200 may be mounted on an interposer substrate other than the main board 2001, and may be connected to each other through wiring lines formed on the interposer substrate.

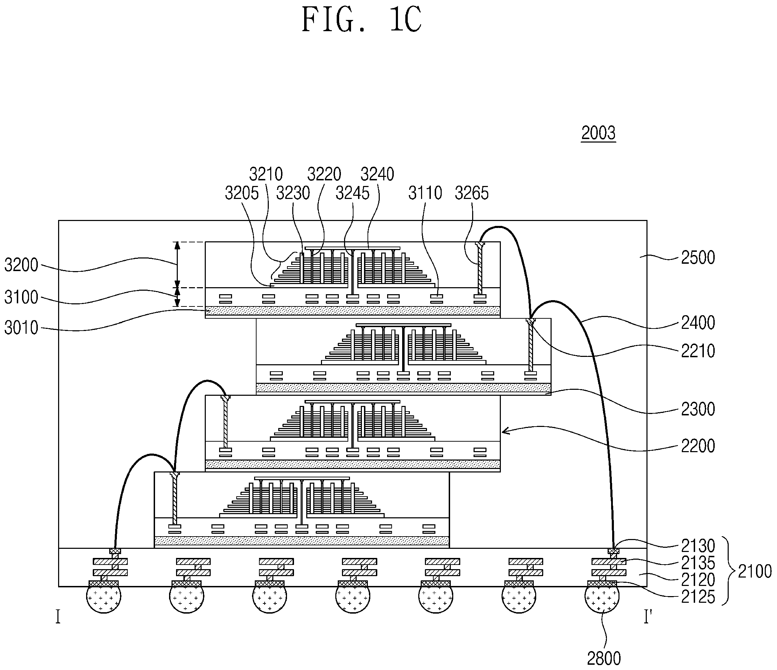

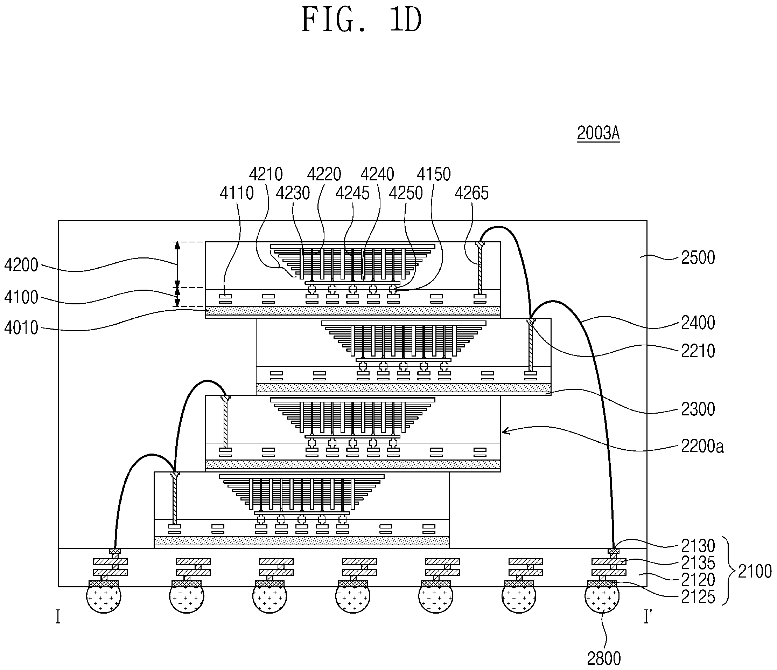

FIGS. 1C and 1D illustrate simplified cross-sectional views showing a semiconductor package according to some embodiments of the present inventive concepts. FIGS. 1C and 1D each depicts an embodiment of the semiconductor package shown in FIG. 1B, conceptually showing a section taken along line I-I' of the semiconductor package shown in FIG. 1B. Referring to FIG. 1C, a printed circuit board may be used as the package substrate 2100 of the semiconductor package 2003. The package substrate 2100 may include a package substrate body 2120, upper pads (see 2130 of FIG. 1B) disposed on a top surface of the package substrate body 2120, lower pads 2125 disposed or exposed on a bottom surface of the package substrate body 2120, and internal wiring lines 2135 through which the upper pads 2130 and the lower pads 2125 are electrically connected in the package substrate body 2120. The upper pads 2130 may be electrically connected to the connection structures 2400. The lower pads 2125 may be connected through conductive connectors 2800 to the wiring patterns 2005 on the main board 2001 of the electronic system 2000, as shown in FIG. 1B.

Each of the semiconductor chips 2200 may include a semiconductor substrate 3010, and may also include a first structure 3100 and a second structure 3200 that are sequentially stacked on the semiconductor substrate 3010. The first structure 3100 may include a peripheral circuit region including peripheral wiring lines 3110. The second structure 3200 may include a source structure 3205, a stack structure 3210 on the source structure 3205, vertical structures 3220 and separation structures 3230 that penetrate the stack structure 3210, bit lines 3240 electrically connected to the vertical structures 3220, and cell contact plugs 3245 electrically connected to word lines (see WL of FIG. 1A) of the stack structure 3210. Each of the first structure 3100, the second structure 3200, and the semiconductor chips 2200 may further include structures which are discussed above.

Each of the semiconductor chips 2200 may include one or more through wiring lines 3245 that extend into the second structure 3200 and are electrically connected to the peripheral wiring lines 3110 of the first structure 3100. The through wiring line 3245 may be disposed outside the stack structure 3210 and may further be disposed to penetrate the stack structure 3210. Each of the semiconductor chips 2200 may further include input/output pads (see 2210 of FIG. 1B) electrically connected to the peripheral wiring lines 3110 of the first structure 3100. Each of the semiconductor chips 2200 may further include an input/output connection interconnection 3265 electrically connected to the peripheral wiring lines 3110 of the first structure 3100 and extending into the second structure 3200, and an input/output pad 2210 electrically connected to the input/output connection interconnection 3265.

Referring to FIG. 1D, in a semiconductor package 2003A, each of semiconductor chips 2200a may include a semiconductor substrate 4010, a first structure 4100 on the semiconductor substrate 4010, and a second structure 4200 disposed on and wafer-bonded to the first structure 4100. The first structure 4100 may include a peripheral circuit region including peripheral wiring lines 4110 and first bonding structures 4150. The second structure 4200 may include a source structure (not shown), a stack structure 4210 between the source structure and the first structure 4100, vertical structures 4220 and separation structures 4230 that penetrate the stack structure 4210, and second bonding structures 4250 electrically connected to corresponding word lines (see WL of FIG. 1A) of the stack structure 4210. For example, the second bonding structures 4250 may be electrically connected to the vertical structures 4220 and the word lines (see WL of FIG. 1A) through bit lines 4240 electrically connected to the vertical structures 4220 and cell contact plugs 4245 electrically connected to the word lines (see WL of FIG. 1A). The first bonding structures 4150 of the first structure 4100 and the second bonding structures 4250 of the second structure 4200 may be bonded to each other while being in contact with each other. The first and second bonding structures 4150 and 4250 may have their bonding portions formed of, for example, copper (Cu).

Each of the first structure 4100, the second structure 4200, and the semiconductor chip 2200a may further include a structure which will be discussed below. Each of the semiconductor chips 2200a may further include input/output pads (see 2210 of FIG. 1B) electrically connected to the peripheral wiring lines 4110 of the first structure 4100. Each of the semiconductor chips 2200a may further include an input/output connection interconnection 4265 electrically connected to the peripheral wiring lines 4110 of the first structure 4100 and extending into the second structure 4200, and an input/output pad 2210 electrically connected to the input/output connection interconnection 4265.

The semiconductor chips 2200 of FIG. 1C may be electrically connected to each other through the connection structures 2400 shaped like bonding wires, and the same may be true for the semiconductor chips 2200a of FIG. 1D. In some embodiments, connection structures including through electrodes (TSV) may be used to electrically connect to each other semiconductor chips, such as the semiconductor chips 2200 of FIG. 1C or the semiconductor chips 2200a of FIG. 1D, in a single semiconductor package.

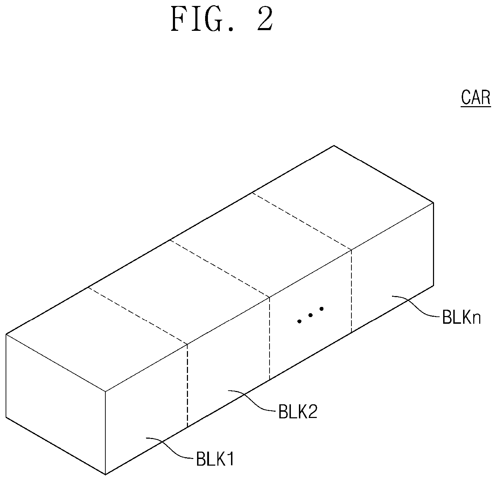

FIG. 2 illustrates a simplified block diagram showing a memory cell array of a semiconductor device according to some embodiments of the present inventive concepts. Referring to FIG. 2, a semiconductor device according to some embodiments may include a memory cell array and a peripheral circuit that controls the memory cell array. The peripheral circuit may include a decoder (see 1110 of FIG. 1A), a page buffer (see 1120 of FIG. 1A), and a logic circuit (see 1130 of FIG. 1A). The memory cell array CAR may include a plurality of memory blocks BLK1, BLK2, ... , and BLKn, where n is a positive integer. Each of the memory blocks BLK1, BLK2, ... , and BLKn may include a stack structure having conductive patterns staked along a third direction D3 on a plane elongated along first and second directions D1 and D2 that intersect each other. The stack structure may combine with a plurality of vertical structures (vertical structures) to constitute three-dimensionally arranged memory cells. In addition, each of the memory blocks BLK1, BLK2, ... , and BLKn may include word lines and bit lines that are electrically connected to the memory cells. Each of the memory blocks BLK1, BLK2, ... , and BLKn may include a plurality of pages, and each of the plurality of pages may include a plurality of memory cells. For example, the memory blocks BLK1, BLK2, ... , and BLKn may be an erase unit, and the page may be a write unit or a read unit. Each memory cell may store one or more bits, and for example, may be used as a single level cell (SLC), a multilevel cell (MLC), a triple level cell (TLC), or a quadruple level cell (QLC).

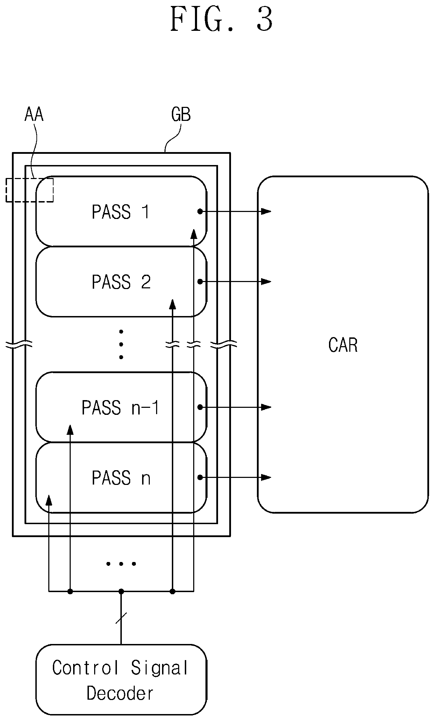

FIG. 3 illustrates a simplified block diagram showing a semiconductor device according to some embodiments of the present inventive concepts. Referring to FIG. 3, there may be provided pass regions PASS 1, PASS 2, ... , and PASS n (where n is a positive integer) including pass transistors between a cell array region CAR and decoders (see 1110 of FIG. 1A). The pass transistors on the pass regions PASS 1, PASS 2, ... , and PASS n may be electrically connected to a memory cell array on the cell array region CAR. A control signal decoder may control the pass transistors. A guard band GB may be provided to surround the pass regions PASS 1, PASS 2, ... , and PASS n. The guard band GB may be interposed between the pass regions PASS 1, PASS 2, ... , and PASS n and the decoders (see 1110 of FIG. 1A) and between the pass regions PASS 1, PASS 2, ... , and PASS n and the cell array region CAR.

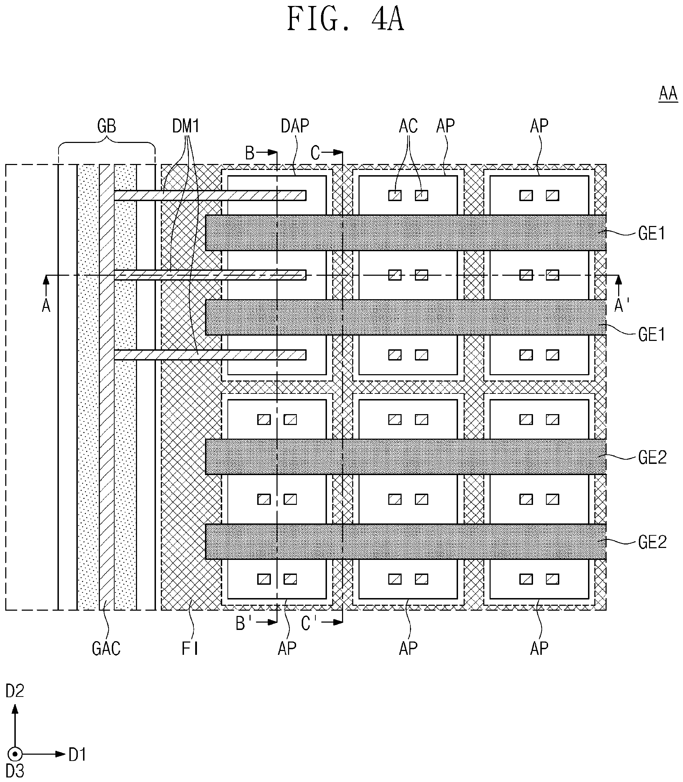

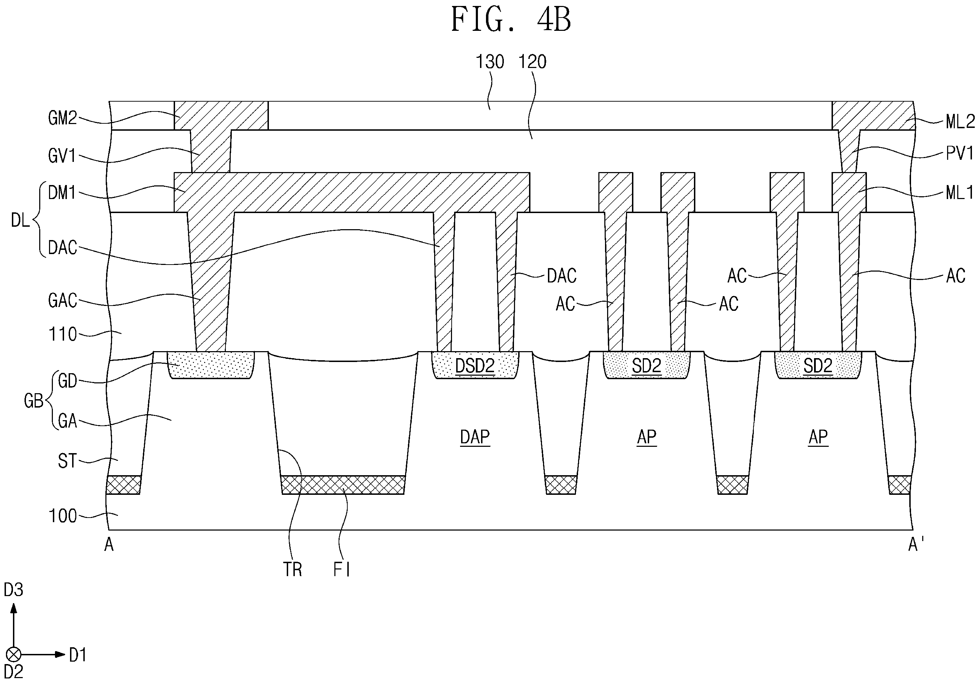

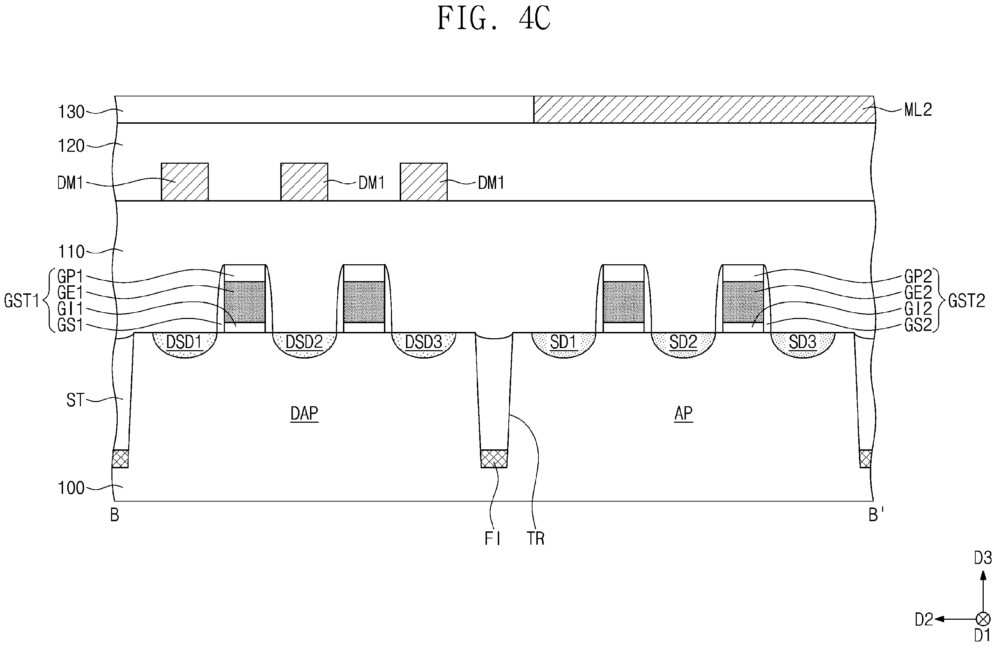

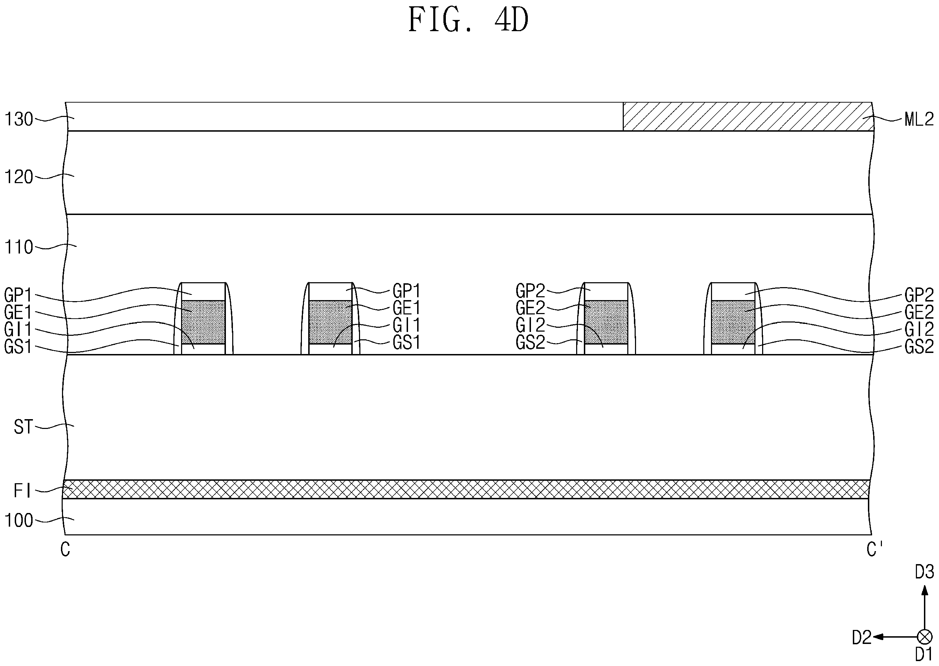

FIG. 4A illustrates an enlarged view of section AA of FIG. 3, showing a semiconductor device according to some embodiments of the present inventive concepts. FIG. 4B illustrates a cross-sectional view taken along line A-A' of FIG. 4A. FIG. 4C illustrates a cross-sectional view taken along line B-B' of FIG. 4A. FIG. 4D illustrates a cross-sectional view taken along line C-C' of FIG. 4A. Referring to FIGS. 4A to 4D, a substrate 100 may be provided thereon with a guard band active pattern GA, a dummy active pattern DAP, and active patterns AP. In an embodiment, two or more dummy active patterns DAP may be provided.

The guard band active pattern GA, the dummy active pattern DAP, and the active patterns AP may be defined by at least one trench TR formed on an upper portion of the substrate 100. The guard band active pattern GA, the dummy active pattern DAP, and the active patterns AP may be portions of the substrate 100, and the portions may protrude in a third direction D3 perpendicular to the substrate 100.

A field doping region FI may be provided in the substrate 100. The field doping region FI may be provided in the substrate 100 between the guard band active pattern GA and the dummy active pattern DAP, between the guard band active pattern GA and the active patterns AP, between the dummy active pattern DAP and the active patterns AP, and between each of the active patterns AP. The field doping region FI may overlap and be aligned with a device isolation layer ST, which will be discussed below. The field doping region FI may extend in a first direction D1 and a second direction D2. For example, the field doping region FI may not overlap any of the guard band active pattern GA, the dummy active pattern DAP, and the active patterns AP. The field doping region FI may be formed by ion implantation, and may include one of B, BF₂, and combinations thereof. In one example, the field doping region may include or comprise a doped impurity in the substrate. In one example, the field doping region may have an impurity therein that extends into the substrate.

A device isolation layer ST may be provided in (e.g. embedded in) the substrate 100. The device isolation layer ST may fill the at least one trench TR. The device isolation layer ST may include a silicon oxide layer or a silicon nitride layer, or another compatible electrically insulating layer. A top surface of the device isolation layer ST may be located at the same level or at a lower level than that of a top surface of the dummy active pattern DAP and that of the top surfaces of the active patterns AP. The device isolation layer ST may be disposed on the field doping region FI and aligned thereto.

As illustrated on the left side of FIG. 4B, a guard doping region GD may be provided as an impurity region in the guard band active pattern GA. The guard doping region GD may be an impurity region of a first conductivity type (e.g., p-type). A guard band GB may include the guard band active pattern GA and the guard doping region GD.

The dummy active pattern DAP may be provided therein with first, second, and third dummy source/drain regions DSD1, DSD2, and DSD3. The first, second, and third dummy source/drain regions DSD1, DSD2, and DSD3 may be impurity regions of the first conductivity type (e.g., p-type). The first, second, and third dummy source/drain regions DSD1, DSD2, and DSD3 may be spaced apart from each other in the second direction D2.

Each of the active patterns AP may be provided therein with first, second, and third source/drain regions SD1, SD2, and SD3. The first, second, and third source/drain regions SD1, SD2, and SD3 may be impurity regions of a second conductivity type (e.g., n-type). The first, second, and third source/drain regions SD1, SD2, and SD3 may be spaced apart from each other in the second direction D2. For example, ion implantation may be employed to form the first, second, and third dummy source/drain regions DSD1, DSD2, and DSD3 and the first, second, and third source/drain regions SD1, SD2, and SD3. In one example, the plurality of pass transistors have source/drain regions SD1, SD2, and SD3 in the plurality of active patterns AP.

First and second gate structures GST1, GST2 may be provided running across the dummy active pattern DAP and the active patterns AP. Each of the first gate structures GST1 may include a first gate electrode GE1, a first gate dielectric layer GI1, a first gate spacer GS1, and a first gate capping pattern GP1. Each of the second gate structures GST2 may include a second gate electrode GE2, a second gate dielectric layer GI2, a second gate spacer GS2, and a second gate capping pattern GP2.

Each of the first and second gate electrodes GE1 and GE2 may extend in the first direction D1. The first gate electrodes GE1 may be provided between the first dummy source/drain region DSD1 and the second dummy source/drain region DSD2 and between the second dummy source/drain region DSD2 and the third dummy source/drain region DSD3, and each of the first gate electrodes GE1 may extend onto the active patterns AP between the first source/drain regions SD1 and the second source/drain regions SD2 and between the second source/drain regions SD2 and the third source/drain regions SD3. The second gate electrodes GE2 may be provided on the active patterns AP between the first source/drain regions SD1 and the second source/drain regions SD2 and between the second source/drain regions SD2 and the third source/drain regions SD3.

Dummy transistors and pass transistors according to the present embodiment may be planar MOSFETs. A pair of the first gate spacers GS1 may be provided on opposite sidewalls of each of the first gate electrodes GE1. The first gate spacers GS1 may extend in the first direction D1 along the first gate electrodes GE1. The first gate spacers GS1 may have their top surfaces higher than those of the first gate electrodes GE1. The top surfaces of the first gate spacers GS1 may be coplanar with those of the first gate capping patterns GP1 which will be discussed below. The first gate capping patterns GP1 may be provided on the first gate electrodes GE1. The first gate capping patterns GP1 may extend in the first direction D1 along the first gate electrodes GE1.

The first gate dielectric layers GI1 may be interposed between the first gate electrodes GE1 and the dummy active pattern DAP. The first gate dielectric layers GI1 may cover a top surface of the device isolation layer ST that underlies the first gate electrodes GE1.

A pair of second gate spacers GS2 may be disposed on opposite sidewalls of each of the second gate electrodes GE2. The second gate spacers GS2 may extend in the first direction D1 along the second gate electrodes GE2. The second gate spacers GS2 may have their top surfaces higher than those of the second gate electrodes GE2. The top surfaces of the second gate spacers GS2 may be coplanar with those of the second gate capping patterns GP2 which will be discussed below.

For example, the first and second gate spacers GS1 and GS2 may include at least one selected from SiCN, SiCON, and SiN. For another example, the first and second gate spacers GS1 and GS2 may include a multiple layer formed of two or more of SiCN, SiCON, and SiN.

The second gate capping patterns GP2 may be provided on the second gate electrodes GE2. The second gate capping patterns GP2 may extend in the first direction D1 along the second gate electrodes GE2. The first and second gate capping patterns GP1 and GP2 may include a material having an etch selectivity with respect to a first interlayer dielectric layer 110 which will be discussed below. For example, the first and second gate capping patterns GP1 and GP2 may include at least one selected from SiON, SiCN, SiCON, and SiN.

The second gate dielectric layers GI2 may be interposed between the second gate electrodes GE2 and the active patterns AP. The second gate dielectric layers GI2 may cover a top surface of the device isolation layer ST that underlies the second gate electrodes GE2. In an embodiment of the present inventive concepts, the first and second gate dielectric layers GI1 and GI2 may include one or more of a silicon oxide layer, a silicon oxynitride layer, and a high-k dielectric layer. For example, the first and second gate dielectric layers GI1 and GI2 may have a structure in which a silicon oxide layer and a high-k dielectric layer are stacked. The high-k dielectric layer may include a high-k dielectric material whose dielectric constant is greater than that of a silicon oxide layer. For example, the high-k dielectric material may include at least one selected from hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

Referring still to FIGS. 4A to 4D, a first interlayer dielectric layer 110 may be provided on the substrate 100. The first interlayer dielectric layer 110 may cover the first and second gate spacers GS1 and GS2, the first and second gate capping patterns GP1 and GP2, the first, second, and third source/drain regions SD1, SD2, and SD3, the first, second, and third dummy source/drain regions DSD1, DSD2, and DSD3, and the device isolation layer ST. A second interlayer dielectric layer 120 may be disposed on the first interlayer dielectric layer 110. A third interlayer dielectric layer 130 may be provided on the second interlayer dielectric layer 120. For example, the first to third interlayer dielectric layers 110 to 130 may include a silicon oxide layer.

A guard active contact GAC may be provided to penetrate the first interlayer dielectric layer 110 to come into electrical connection with the guard doping region GD. When viewed in plan, the guard active contact GAC may have a bar shape that extends in the second direction D2.

Dummy active contacts DAC may be provided to penetrate the first interlayer dielectric layer 110 to correspondingly come into electrical connection with the first, second, and third dummy source/drain regions DSD1, DSD2, and DSD3. A pair of dummy active contacts DAC may be provided on opposite sides of each of the first gate electrodes GE1. When viewed in a plan layout perspective, the dummy active contacts DAC may have a bar shape that extends in the first direction D1.

Active contacts AC may be provided to penetrate the first interlayer dielectric layer 110 to correspondingly come into electrical connection with the first, second, and third source/drain regions SD1, SD2, and SD3. A pair of active contacts AC may be provided on opposite sides of each of the second gate electrodes GE2. When viewed in a plan perspective, the active contacts AC may have a bar shape that extends in the first direction D1.

Dummy wiring lines DL may be provided in the first and second interlayer dielectric layers 110 and 120. Each of the dummy wiring lines DL may include a first dummy metal line DM1 and dummy active contacts DAC. The dummy wiring lines DL may be connected to the guard active contact GAC to electrically connect the dummy active pattern DAP to the guard band GB.

The second interlayer dielectric layer 120 may be provided therein with first dummy metal lines DM1, first metal lines ML1, first guard vias GV1, and first vias PV1. The first dummy metal lines DM1 and the first metal lines ML1 may parallel extend in the first direction D1. The first metal lines ML1 may be connected to the active contacts AC.

The first dummy metal lines DM1 may electrically connect the guard active contact GAC to the first dummy source/drain region DSD1, the guard active contact GAC to the second dummy source/drain region DSD2, and the guard active contact GAC to the third dummy source/drain region DSD3. Thus, the dummy transistor on the dummy active pattern DAP may not be in a floating state. The dummy transistor may be electrically connected to the guard band GB and thus electrically separated from the pass transistors on the active patterns AP. Therefore, when a semiconductor device is operated (e.g., a program operation), a depletion region caused by the dummy transistor may not overlap a depletion region caused by the pass transistors. In addition, the dummy transistor may have a reduced effect on breakdown voltages and threshold voltages of the pass transistors. Thus, the pass transistors may decrease in distribution of threshold voltage and breakdown voltage and may improve in distribution characteristics.

The first guard vias GV1 may connect the first dummy metal lines DM1 to second guard metal lines GM2 which will be discussed below. The first vias PV1 may connect the first metal lines MI,1 to second metal lines ML2 which will be discussed below.

The third interlayer dielectric layer 130 may be provided therein with second guard metal lines GM2 and second metal lines ML2. The second guard metal lines GM2 and the second metal lines ML2 may parallel extend in the second direction D2.

The second metal lines ML2 may be electrically connected to a plurality of word lines that are vertically stacked in a memory cell array. Therefore, the pass transistors may be electrically connected to the memory cell array. The second guard metal lines GM2 and the first guard vias GV1 may be individually formed by separate processes, and the second metal lines ML2 and the first vias PV1 may be individually formed by separate processes.

A conductive material may be used to form the active contacts AC, the guard active contact GAC, the dummy active contacts DAC, the first dummy metal lines DM1, the first and second metal lines MI,1 and ML2, the first guard vias GV1, the first vias PV1, and the first and second guard metal lines GM1 and GM2. In an embodiment, the conductive material may include at least one metallic material selected from aluminum, copper, tungsten, molybdenum, ruthenium, and cobalt.

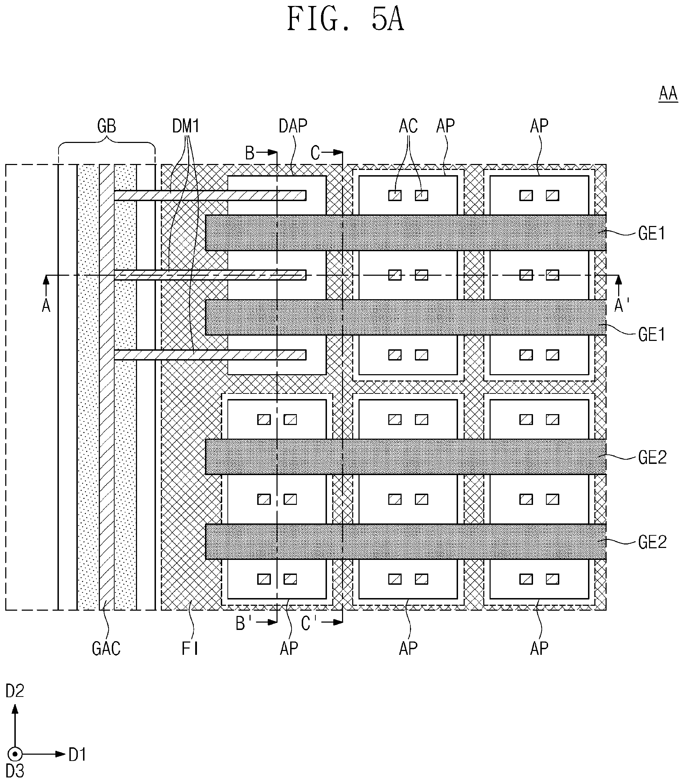

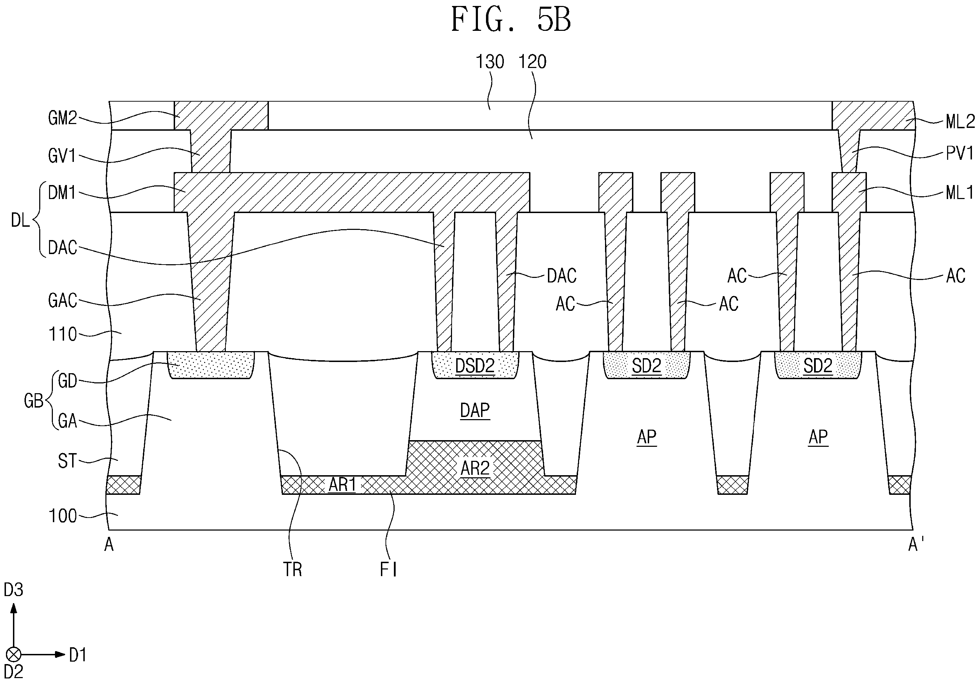

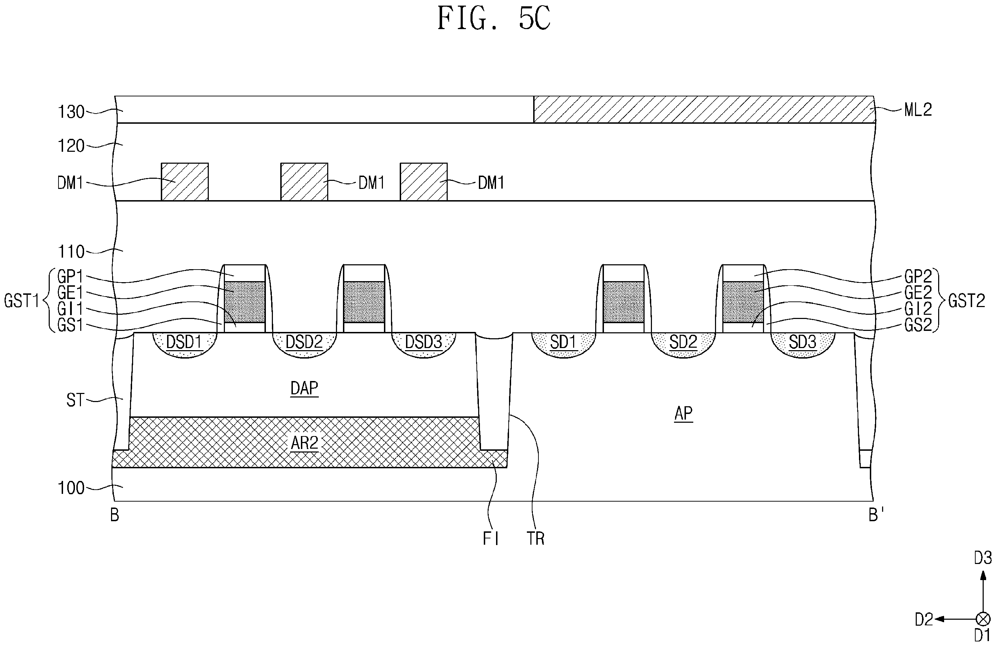

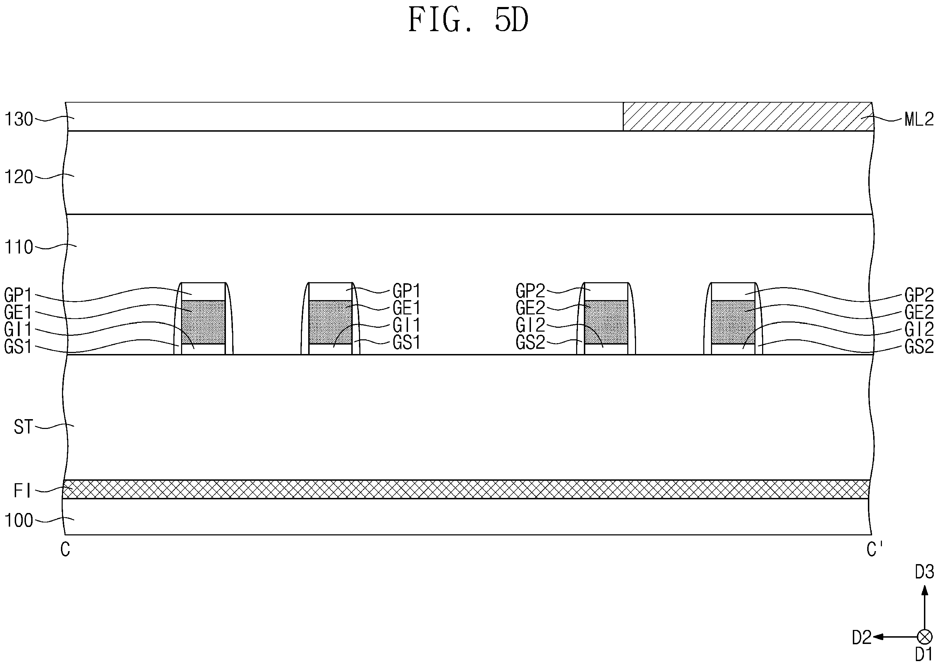

FIG. 5A illustrates an enlarged cross-sectional view of section AA of FIG. 3, showing a semiconductor device according to some embodiments of the present inventive concepts. FIG. 5B illustrates a cross-sectional view taken along line A-A' of FIG. 5A. FIG. 5C illustrates a cross-sectional view taken along line B-B' of FIG. 5A. FIG. 5D illustrates a cross-sectional view taken along line C-C' of FIG. 5A. The following will focus on a difference from the aforementioned semiconductor device according to an embodiment of the present inventive concepts. A detailed explanation of components identical or similar to those discussed above will be omitted in the interest of brevity of description.

Referring to FIGS. 5A to 5D, the field doping region FI may be provided in the substrate 100 between the guard band active pattern GA and the dummy active pattern DAP, between the guard band active pattern GA and the active patterns AP, between the dummy active pattern DAP and the active patterns AP, and between each of the active patterns AP. The field doping region FI may overlap the device isolation layer ST. The field doping region FI may extend in the first direction D1 and the second direction D2. For example, the field doping region FI may not overlap any of the guard band active pattern GA and the active patterns AP, but may overlap the dummy active pattern DAP.

The field doping region FI may include a first region AR1 that does not overlap any of the guard band active pattern GA, the dummy active pattern DAP, and the active patterns AP, and may also include a second region AR2 that overlaps the dummy active pattern DAP. For example, the first region AR1 may overlap the device isolation layer ST. When viewed in the third direction D3, the second region AR2 may be thicker than the first region AR1.

When a semiconductor device is operated (e.g., a program operation), the field doping region FI may restrict expansion of a depletion region of the dummy transistor. Therefore, a depletion region caused by the dummy transistor may not overlap a depletion region caused by the pass transistors on the active patterns AP. In addition, the dummy transistor may have a reduced effect on breakdown voltages and threshold voltages of the pass transistors. Thus, the pass transistors may decrease in distribution of threshold voltage and breakdown voltage and may improve in distribution characteristics.

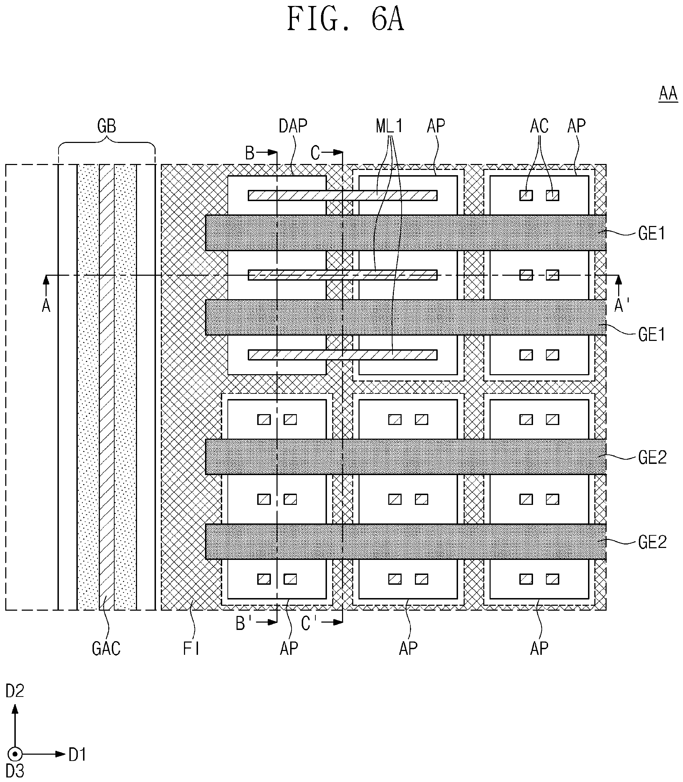

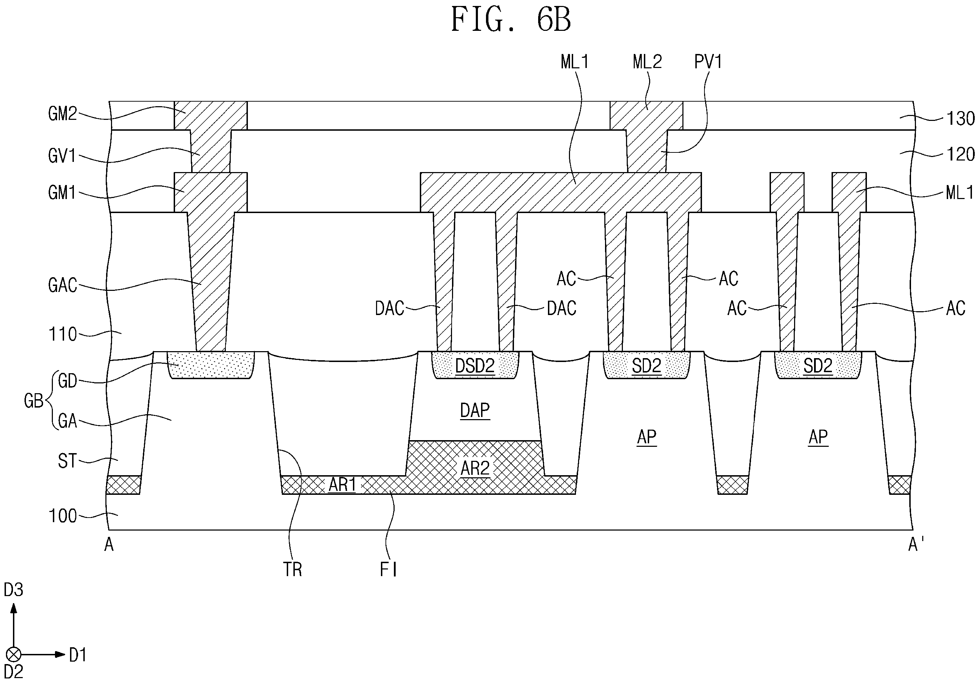

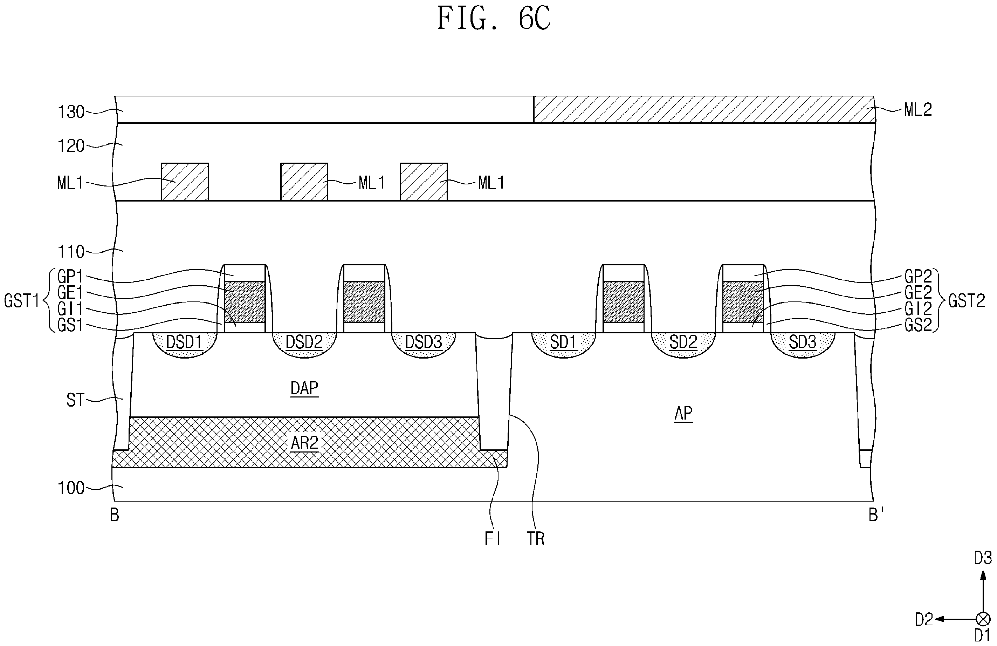

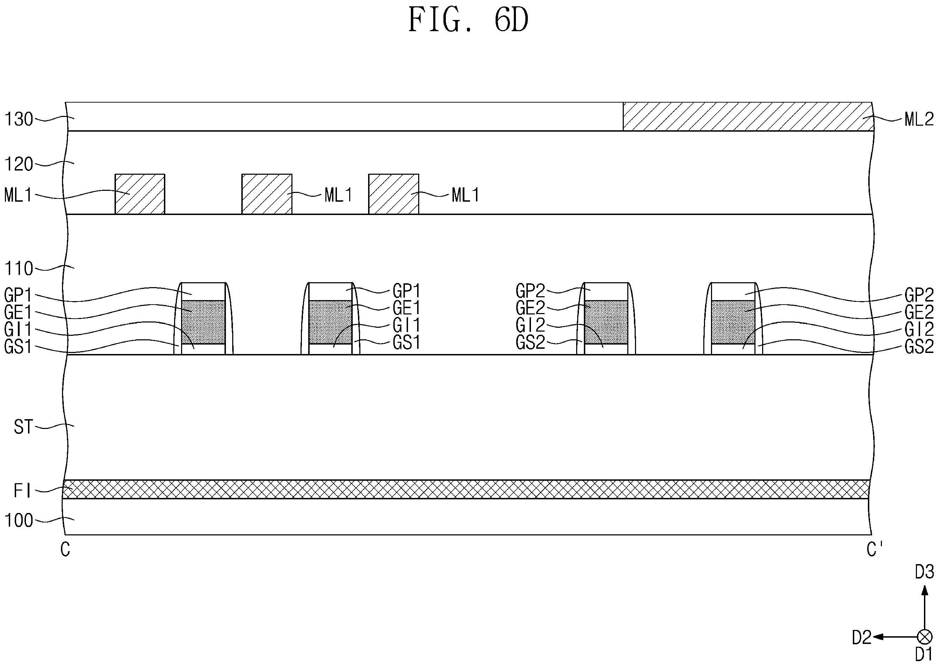

FIG. 6A illustrates an enlarged cross-sectional view of section AA of FIG. 3, showing a semiconductor device according to some embodiments of the present inventive concepts. FIG. 6B illustrates a cross-sectional view taken along line A-A' of FIG. 6A. FIG. 6C illustrates a cross-sectional view taken along line B-B' of FIG. 6A. FIG. 6D illustrates a cross-sectional view taken along line C-C' of FIG. 6A. The following will focus on a difference from the aforementioned semiconductor device according to an embodiment of the present inventive concepts. A detailed explanation of components identical or similar to those discussed above will be omitted in the interest of brevity of description.

Referring to FIGS. 6A to 6D, differently from the embodiments above, the first, second, and third dummy source/drain regions DSD1, DSD2, and DSD3 on the dummy active pattern DAP may be impurity regions of the second conductivity type (e.g., n-type). The second interlayer dielectric layer 120 may be provided therein with a first guard metal line GM1, first metal lines MI,1, first guard vias GV1, and first vias PV1. The first metal lines ML1 may parallel extend in the first direction D1, and the first guard metal line GM1 may extend in the second direction D2.

Differently from the embodiments above, the first metal lines MI,1 may electrically connect a pair of neighboring dummy active contacts DAC to the active contact AC. For example, the first metal lines ML1 may electrically connect the first dummy source/drain region DSD1 to the first source/drain region SD1, the second dummy source/drain region DSD2 to the second source/drain region SD2, and the third dummy source/drain region DSD3 to the third source/drain region SD3. Thus, the dummy transistor on the dummy active pattern DAP may not be in a floating state.

The first guard via GV1 may connect the first guard metal line GM1 to the second guard metal line GM2. The first vias PV1 may connect the first metal lines MI,1 to the second metal lines ML2.

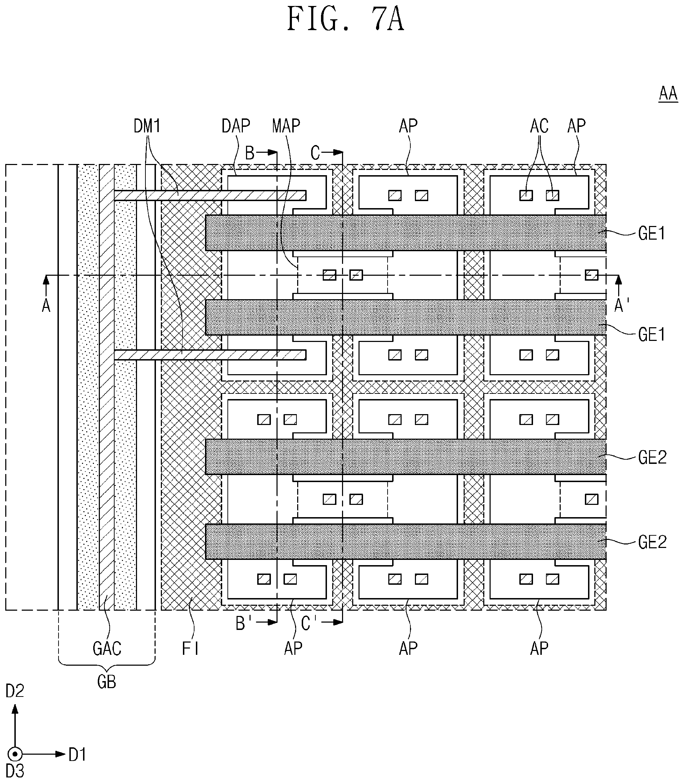

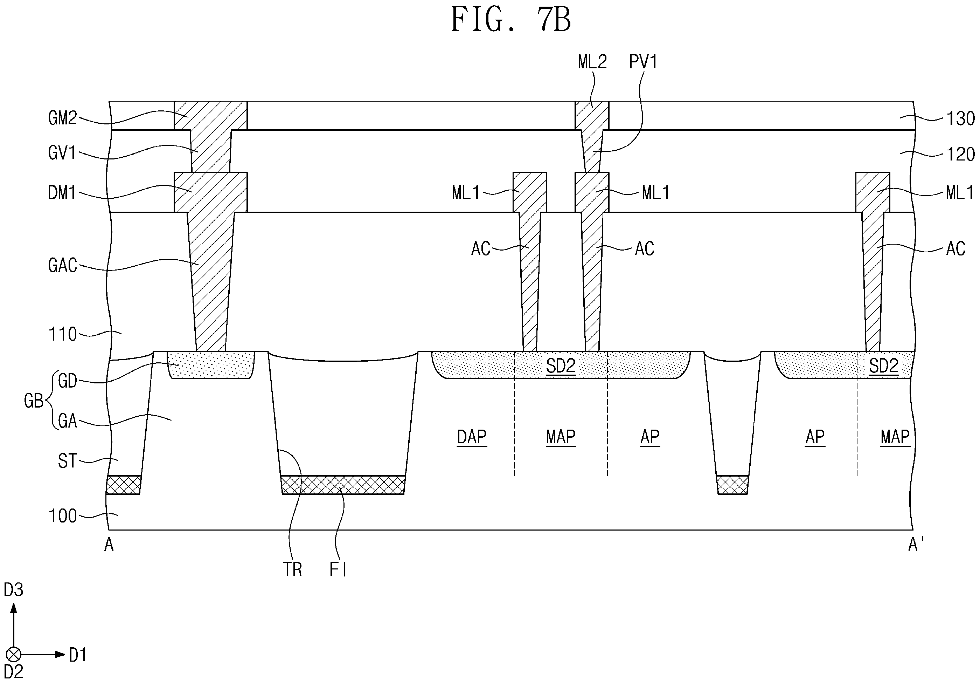

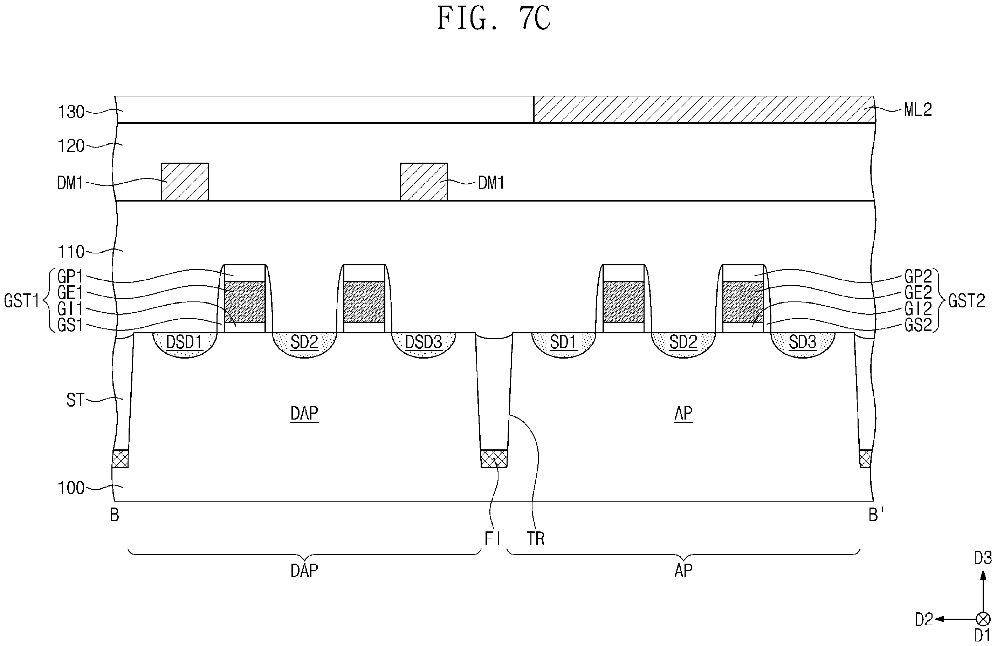

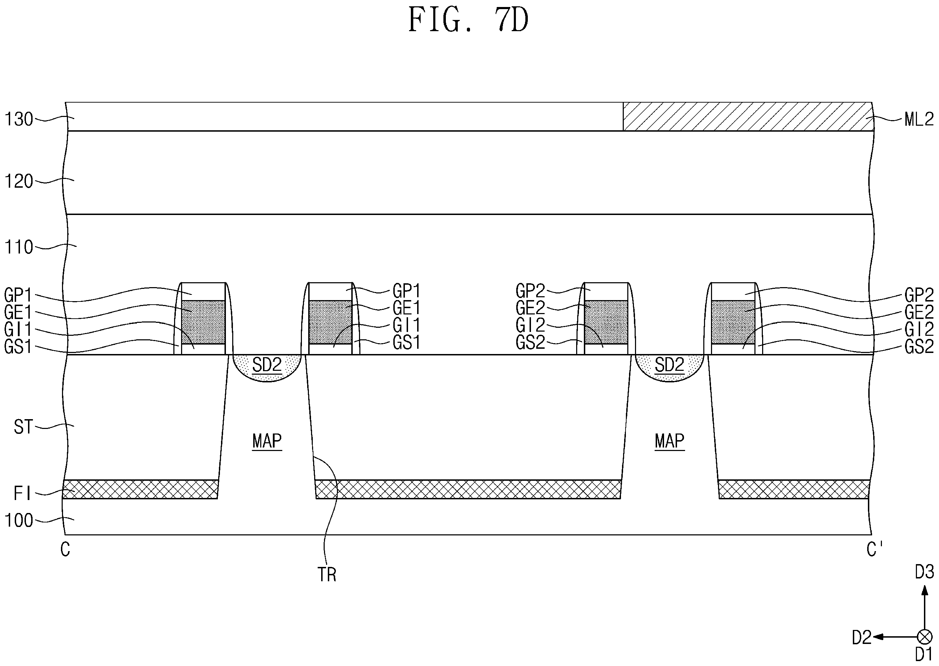

FIG. 7A illustrates an enlarged cross-sectional view of section AA of FIG. 3, showing a semiconductor device according to some embodiments of the present inventive concepts. FIG. 7B illustrates a cross-sectional view taken along line A-A' of FIG. 7A. FIG. 7C illustrates a cross-sectional view taken along line B-B' of FIG. 7A. FIG. 7D illustrates a cross-sectional view taken along line C-C' of FIG. 7A. The following will focus on a difference from the aforementioned semiconductor device according to an embodiment of the present inventive concepts. A detailed explanation of components identical or similar to those discussed above will be omitted in the interest of brevity of description.

Referring to FIGS. 7A to 7D, the substrate 100 may be provided thereon with a guard band active pattern GA, a dummy active pattern DAP, intermediate active patterns MAP, and active patterns AP. In an embodiment, two or more dummy active patterns DAP may be provided. The guard band active pattern GA, the dummy active pattern DAP, the intermediate active patterns MAP, and the active patterns AP may be defined by a trench TR formed on an upper portion of the substrate 100. The guard band active pattern GA, the dummy active pattern DAP, the intermediate active patterns MAP, and the active patterns AP may be portions of the substrate 100, and the portions may protrude in the third direction D3 perpendicular to the substrate 100.

The active patterns AP adjacent to the dummy active pattern DAP may be spaced apart in the first direction D1 and the second direction D2 from the dummy active pattern DAP. The intermediate active pattern MAP may connect the active pattern AP and the dummy active pattern DAP that are adjacently spaced apart from each other in the first direction D1.

First gate electrodes GE1 may be provided to run across the active patterns AP and the dummy active pattern DAP. The intermediate active patterns MAP may be disposed between the first gate electrodes GE1. The active pattern AP and the dummy active pattern DAP that are connected to the intermediate active pattern MAP may be incorporated into a single unitary piece to have an H shape when viewed in plan.

A field doping region FI may be provided in the substrate 100. The field doping region FI may be provided in the substrate 100 between the guard band active pattern GA and the dummy active pattern DAP, between the guard band active pattern GA and the active patterns AP, between the dummy active pattern DAP and the active patterns AP, and between each of the active patterns AP. The field doping region FI may overlap the device isolation layer ST. The field doping region FI may extend in the first direction D1 and the second direction D2. For example, the field doping region FI may not overlap any of the guard band active pattern GA, the dummy active pattern DAP, the intermediate active pattern MAP, and the active patterns AP.

The active patterns AP may be provided therein with first and third source/drain regions SD1 and SD3, the intermediate active patterns MAP may be provided therein with second source/drain regions SD2, and the dummy active pattern DAP may be provided therein with first and third dummy source/drain regions DSD1 and DSD3. The second source/drain region SD2 on each of the intermediate active patterns MAP may extend onto the dummy active pattern DAP and each of the active patterns AP. Thus, the second source/drain regions SD2 may be provided on the active patterns AP and the dummy active pattern DAP.

The first, second, and third source/drain regions SD1, SD2, and SD3 may have the second conductivity type (e.g., n-type), and the first and third dummy source/drain regions DSD1 and DSD3 may have the first conductivity type (e.g., p-type). The second source/drain region SD2 may be spaced apart in the second direction D2 from the first and third source/drain regions SD1 and SD3 and the first and third dummy source/drain regions DSD1 and DSD3.

Active contacts AC may be provided to penetrate the first interlayer dielectric layer 110 to come into electrical connection with the second source/drain regions SD2 on the intermediate active pattern MAP. The first dummy metal lines DM1 may electrically connect the guard doping region GD to the first dummy source/drain region DSD1 and the guard doping region GD to the third dummy source/drain region DSD3. Thus, the dummy transistor on the dummy active pattern DAP may not be in a floating state. The dummy transistor may be electrically connected to the guard band GB and electrically separated from the pass transistors on the active patterns AP. Therefore, a depletion region caused by the dummy transistor may not overlap a depletion region caused by the pass transistors. In addition, the dummy transistor may have a reduced effect on breakdown voltages and threshold voltages of the pass transistors. Thus, the pass transistors may decrease in distribution of threshold voltage and breakdown voltage and may improve in distribution characteristics.

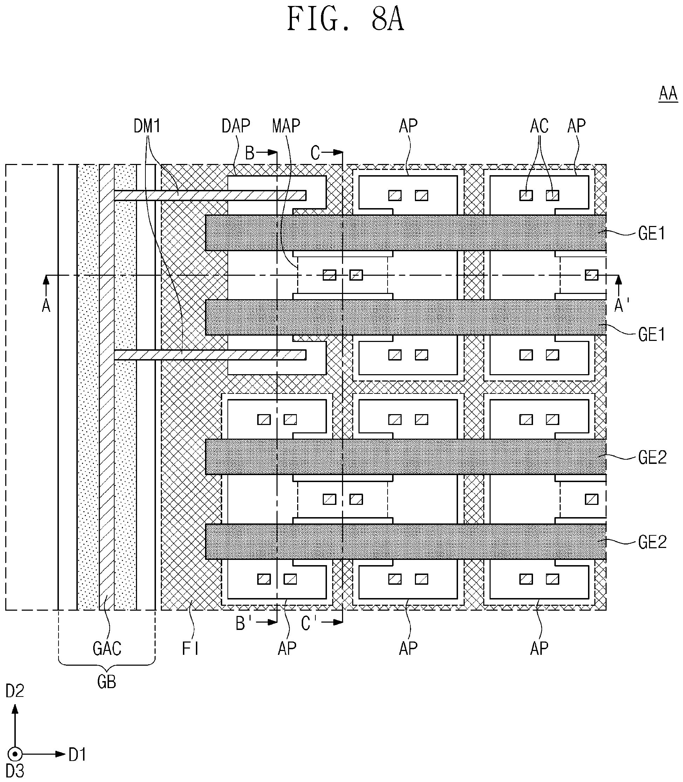

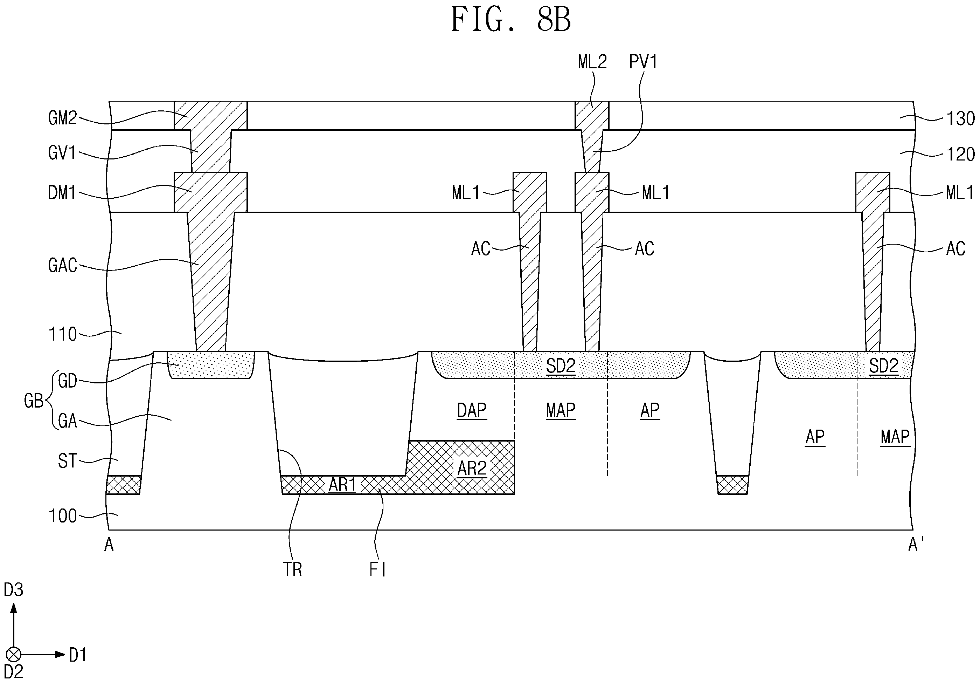

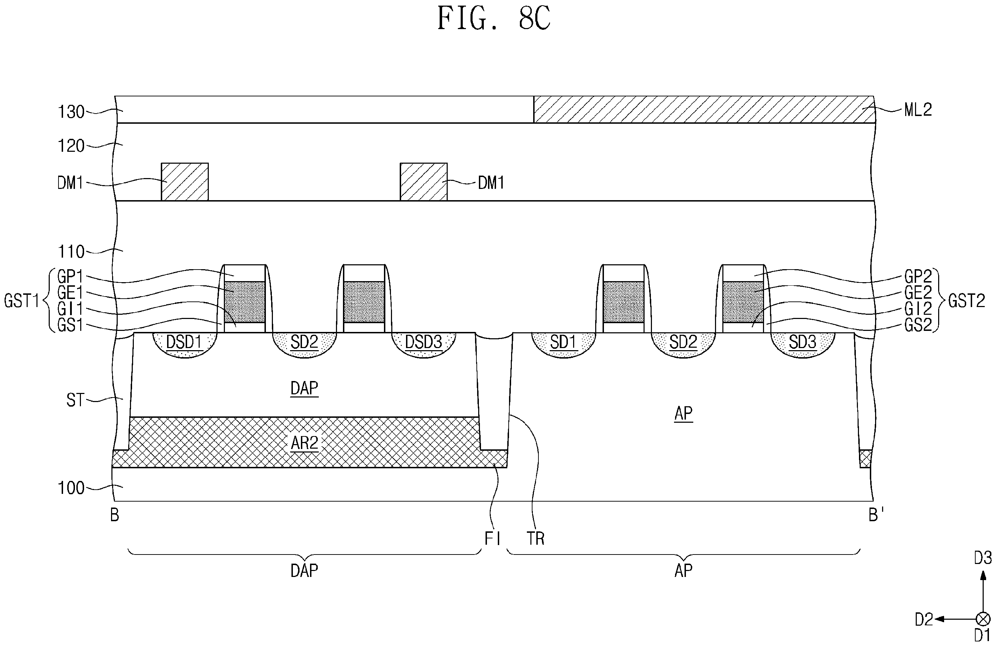

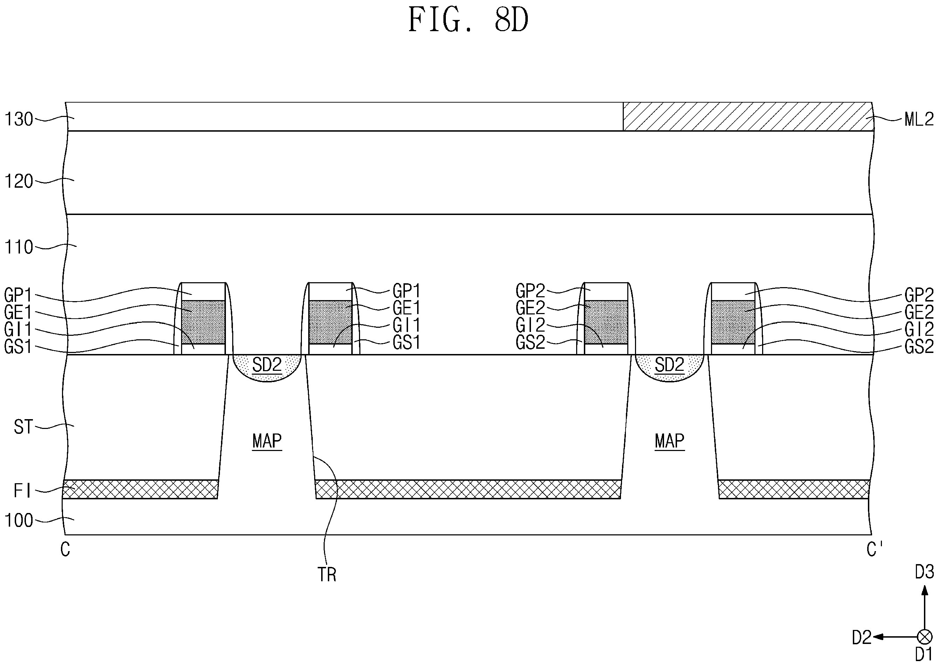

FIG. 8A illustrates an enlarged cross-sectional view of section AA of FIG. 3, showing a semiconductor device according to some embodiments of the present inventive concepts. FIG. 8B illustrates a cross-sectional view taken along line A-A' of FIG. 8A. FIG. 8C illustrates a cross-sectional view taken along line B-B' of FIG. 8A. FIG. 8D illustrates a cross-sectional view taken along line C-C' of FIG. 8A. The following will focus on a difference from the aforementioned semiconductor device according to an embodiment of the present inventive concepts. A detailed explanation of components identical or similar to those discussed above will be omitted in the interest of brevity of description. Referring to FIGS. 8A to 8D, the field doping region FI may not overlap any of the guard band active pattern GA, the intermediate active pattern MAP, and the active patterns AP, but may overlap the dummy active pattern DAP.

The field doping region FI may include a first region AR1 that does not overlap any of the guard band active pattern GA, the dummy active pattern DAP, the intermediate active pattern MAP, and the active patterns AP, and may also include a second region AR2 that overlaps the dummy active pattern DAP. For example, the first region AR1 may overlap the device isolation layer ST. When viewed in the third direction D3, the second region AR2 may be thicker than the first region AR1.

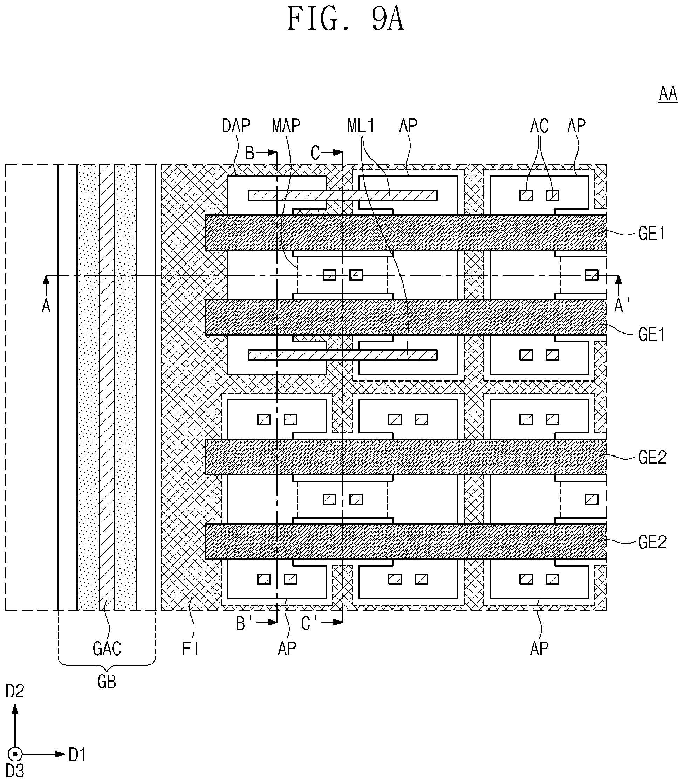

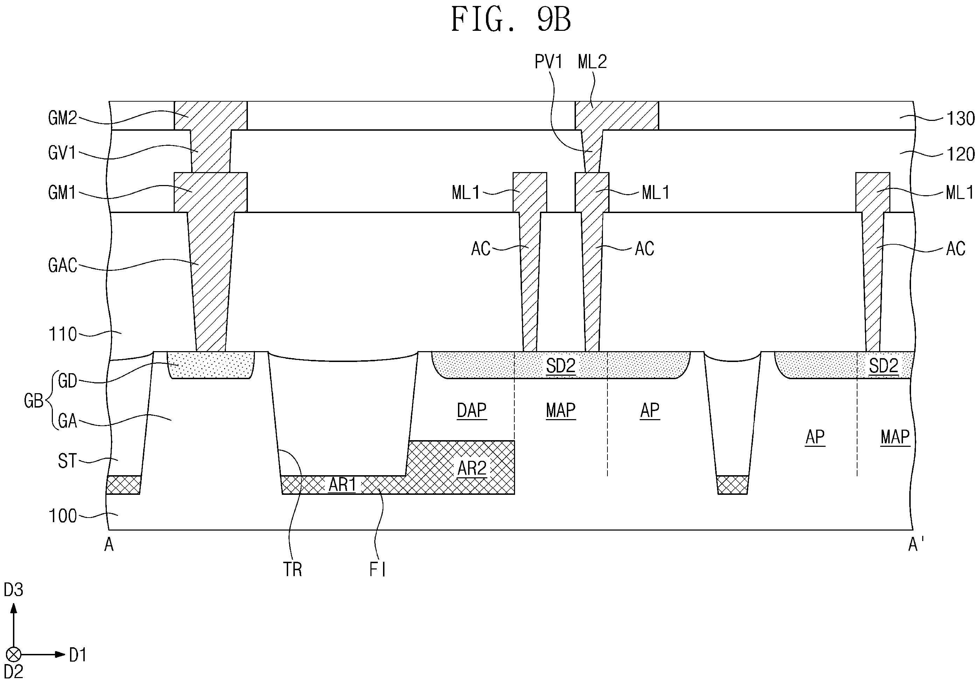

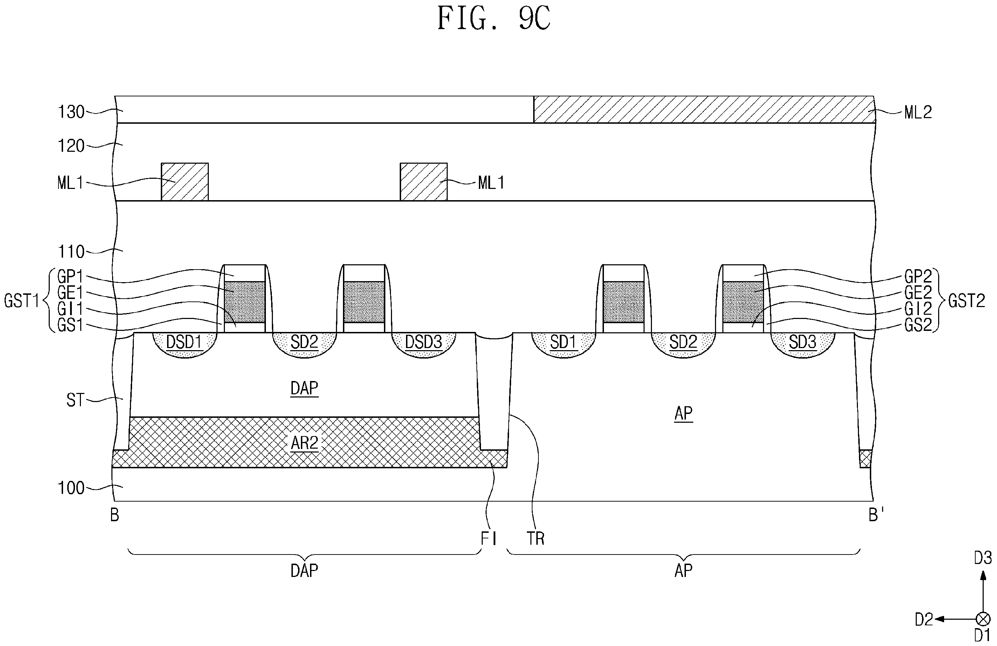

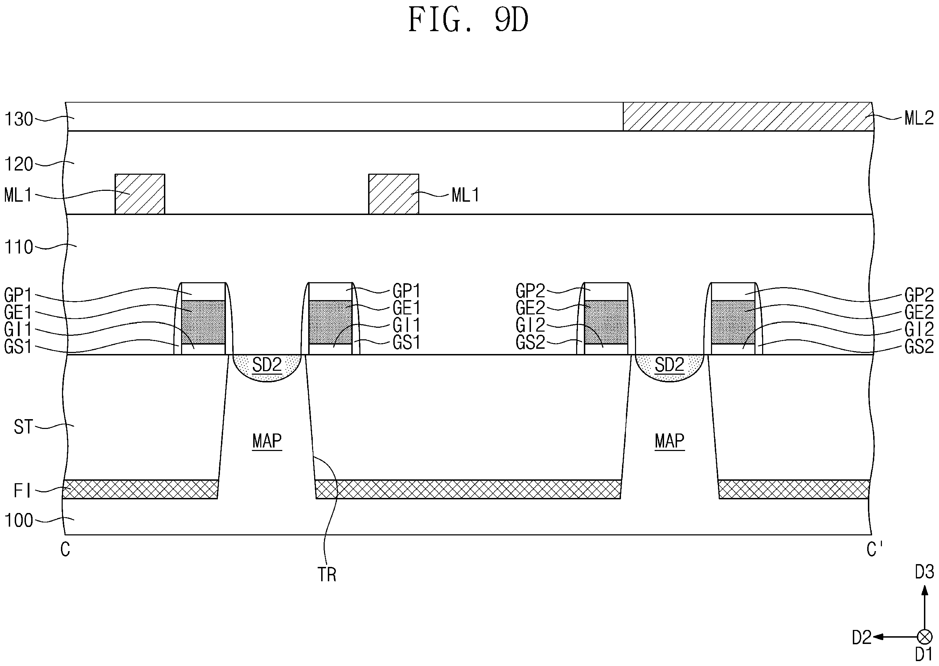

FIG. 9A illustrates an enlarged cross-sectional view of section AA of FIG. 3, showing a semiconductor device according to some embodiments of the present inventive concepts. FIG. 9B illustrates a cross-sectional view taken along line A-A' of FIG. 9A. FIG. 9C illustrates a cross-sectional view taken along line B-B' of FIG. 9A. FIG. 9D illustrates a cross-sectional view taken along line C-C' of FIG. 9A. The following will focus on a difference from the aforementioned semiconductor device according to an embodiment of the present inventive concepts. A detailed explanation of components identical or similar to those discussed above will be omitted in the interest of brevity of description. Referring to FIGS. 9A to 9D, differently from the embodiments above, the first and third dummy source/drain regions DSD1 and DSD3 may have the second conductivity type (e.g., n-type).

The second interlayer dielectric layer 120 may be provided therein with a first guard metal line GM1, first metal lines ML1, first guard vias GV1, and first vias PV1. The first metal lines ML1 may parallel extend in the first direction D1, and the first guard metal line GM1 may extend in the second direction D2. Differently from the embodiments above, the first metal lines MI,1 may electrically connect a pair of neighboring dummy active contacts DAC to the active contact AC. For example, the first metal lines MI,1 may electrically connect the first dummy source/drain region DSD1 to the first source/drain region SD1 and the third dummy source/drain region DSD3 to the third source/drain region SD3. Thus, the dummy transistor on the dummy active pattern DAP may not be in a floating state. The first guard via GV1 may connect the first guard metal line GM1 to the second guard metal line GM2. The first vias PV1 may connect the first metal lines ML1 to the second metal lines ML2.

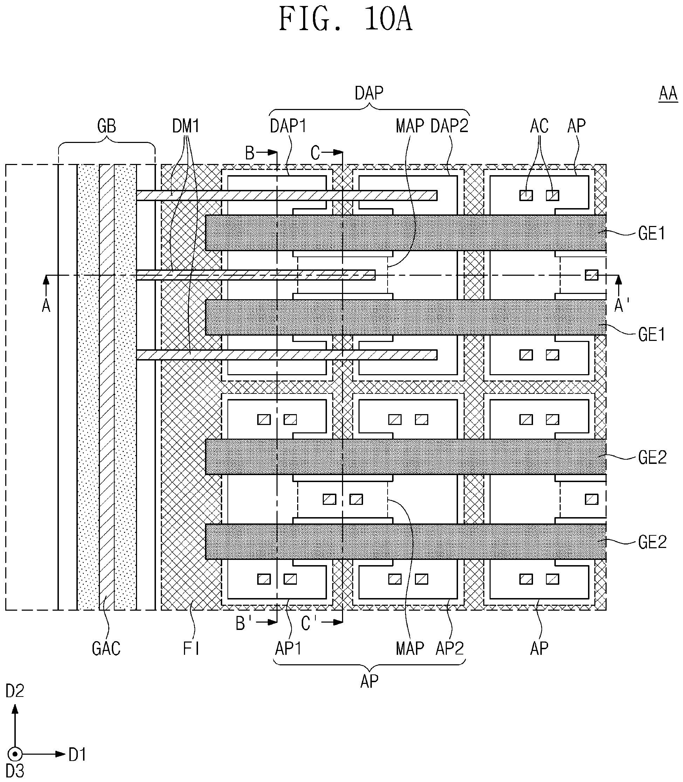

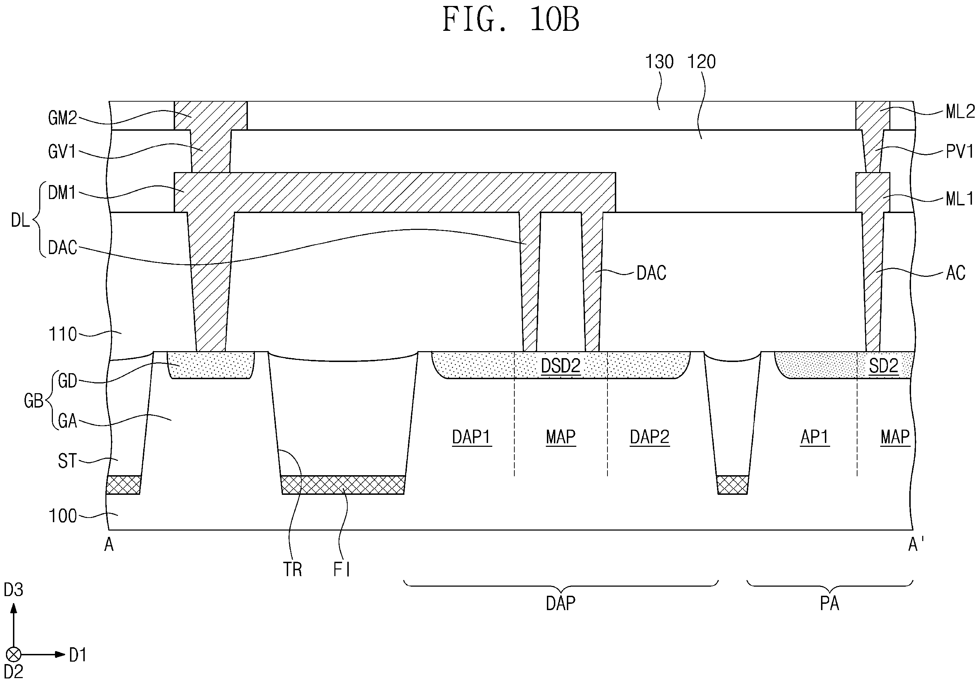

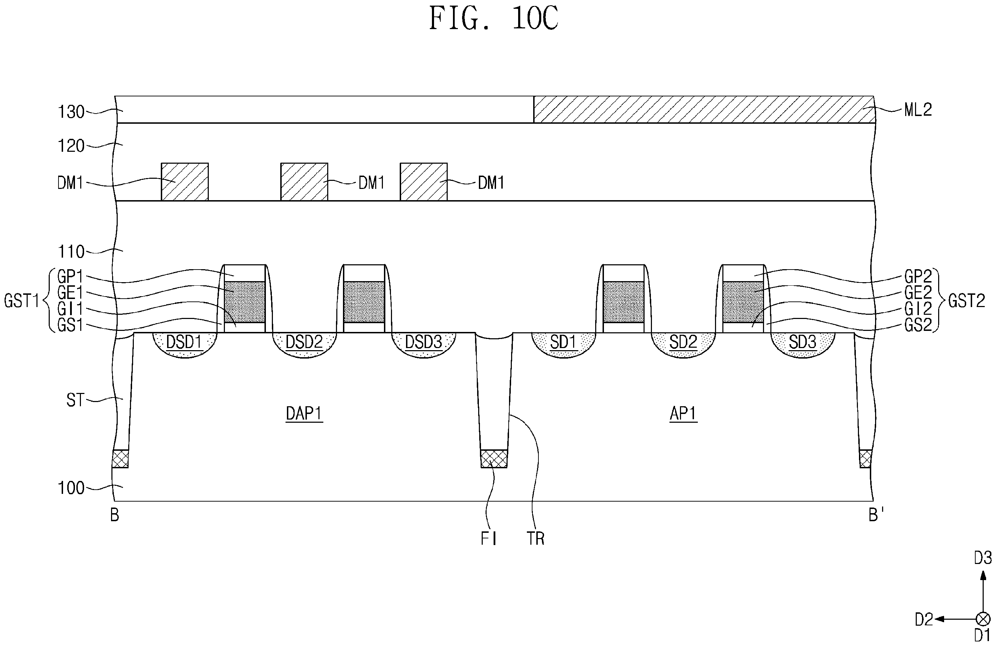

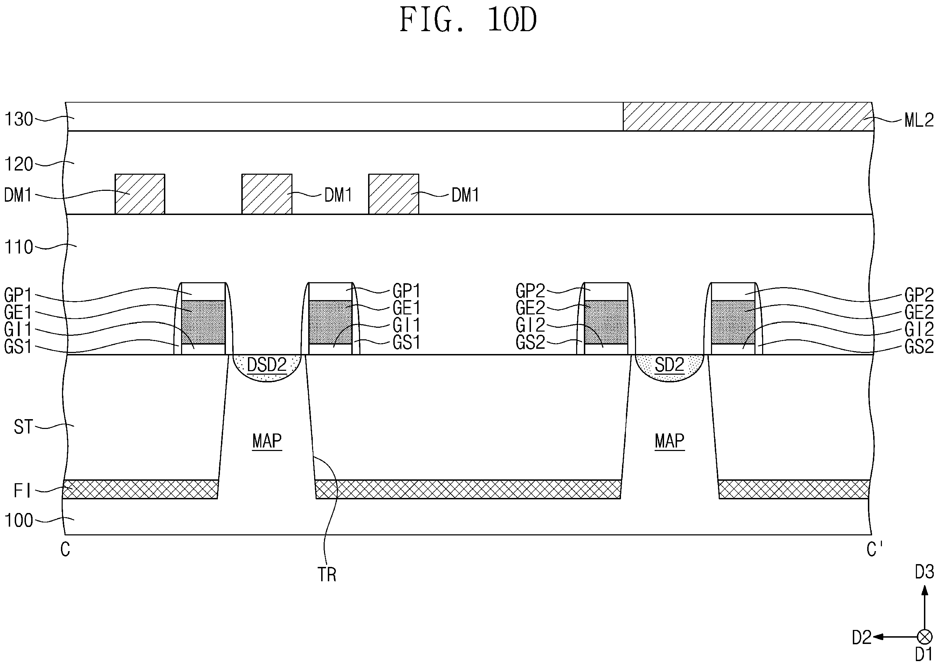

FIG. 10A illustrates an enlarged cross-sectional view of section AA of FIG. 3, showing a semiconductor device according to some embodiments of the present inventive concepts. FIG. 10B illustrates a cross-sectional view taken along line A-A' of FIG. 10A. FIG. 10C illustrates a cross-sectional view taken along line B-B' of FIG. 10A. FIG. 10D illustrates a cross-sectional view taken along line C-C' of FIG. 10A. The following will focus on a difference from the aforementioned semiconductor device according to an embodiment of the present inventive concepts. A detailed explanation of components identical or similar to those discussed above will be omitted in the interest of brevity of description.

Referring to FIGS. 10A to 10D, the substrate 100 may be provided thereon with a guard band active pattern GA, a dummy active pattern DAP, and active patterns AP. In an embodiment, two or more dummy active patterns DAP may be provided. The guard band active pattern GA, the dummy active pattern DAP, and the active patterns AP may be defined by a trench TR formed on an upper portion of the substrate 100. The guard band active pattern GA, the dummy active pattern DAP, and the active patterns AP may be portions of the substrate 100, and the portions may protrude in the third direction D3 perpendicular to the substrate 100.

The dummy active pattern DAP may include an intermediate active pattern MAP, a first dummy active pattern DAP1, and a second dummy active pattern DAP2 that is spaced apart in the first direction D1 from the first dummy active pattern DAP1, and each of the active patterns AP may include an intermediate active pattern MAP, a first active pattern AP1, and a second active pattern AP2 that is spaced apart in the first direction D1 from the first active pattern AP1. The intermediate active patterns MAP may be interposed between the first dummy active pattern DAP1 and the second dummy active pattern DAP2 and between the first active patterns AP1 and the second active patterns AP2. For example, the intermediate active patterns MAP may connect the first dummy active pattern DAP1 to the second dummy active pattern DAP2 and the first active patterns AP1 to the second active patterns AP2. The dummy active pattern DAP and the active patterns AP may have an H shape when viewed in plan.

A field doping region FI may be provided in the substrate 100. The field doping region FI may be provided in the substrate 100 between the guard band active pattern GA and the dummy active pattern DAP, between the guard band active pattern GA and the active patterns AP, between the dummy active pattern DAP and the active patterns AP, and between each of the active patterns AP. The field doping region FI may overlap the device isolation layer ST. The field doping region FI may extend in the first direction D1 and the second direction D2. For example, the field doping region FI may not overlap any of the guard band active pattern GA, the dummy active pattern DAP, the intermediate active pattern MAP, and the active patterns AP.

The first active pattern AP1 and the second active pattern AP2 may be provided thereon with first and third source/drain regions SD1 and SD3, and the intermediate active pattern MAP in the active pattern AP may be provided thereon with a second source/drain region SD2. The second source/drain region SD2 may extend from the intermediate pattern MAP onto its neighboring first and second active patterns AP1 and AP2.

The first dummy active pattern DAP1 and the second dummy active pattern DAP2 may be provided thereon with first and third dummy source/drain regions DSD1 and DSD3, and the intermediate active pattern MAP in the dummy active pattern DAP may be provided thereon with a second dummy source/drain region DSD2. The second dummy source/drain region DSD2 may extend from the intermediate active pattern MAP onto its neighboring first and second dummy active patterns DAP1 and DAP2.

The first, second, and third source/drain regions SD1, SD2, and SD3 may have the second conductivity type (e.g., n-type), and the first, second, and third dummy source/drain regions DSD1, DSD2, and DSD3 may have the first conductivity type (e.g., p-type). The second source/drain region SD2 may be spaced apart in the second direction D2 from the first and third source/drain regions SD1 and SD3, and the second dummy source/drain region DSD2 may be spaced apart in the second direction D2 from the first and third dummy source/drain regions DSD1 and DSD3.

Dummy active contacts DAC may be provided to penetrate the first interlayer dielectric layer 110 to come into electrical connection with the second dummy source/drain regions DSD2 on the intermediate active pattern MAP. The first dummy metal lines DM1 may electrically connect the guard active contact GAC to the first dummy source/drain regions DSD1. The first dummy metal lines DM1 may electrically connect the guard active contact GAC to the second dummy source/drain region DSD2. The first dummy metal lines DM1 may electrically connect the guard active contact GAC to the third dummy source/drain regions DSD3. Thus, the dummy transistor on the dummy active pattern DAP may not be in a floating state. The dummy transistor may be electrically connected to the guard band GB and electrically separated from the pass transistors on the active patterns AP.

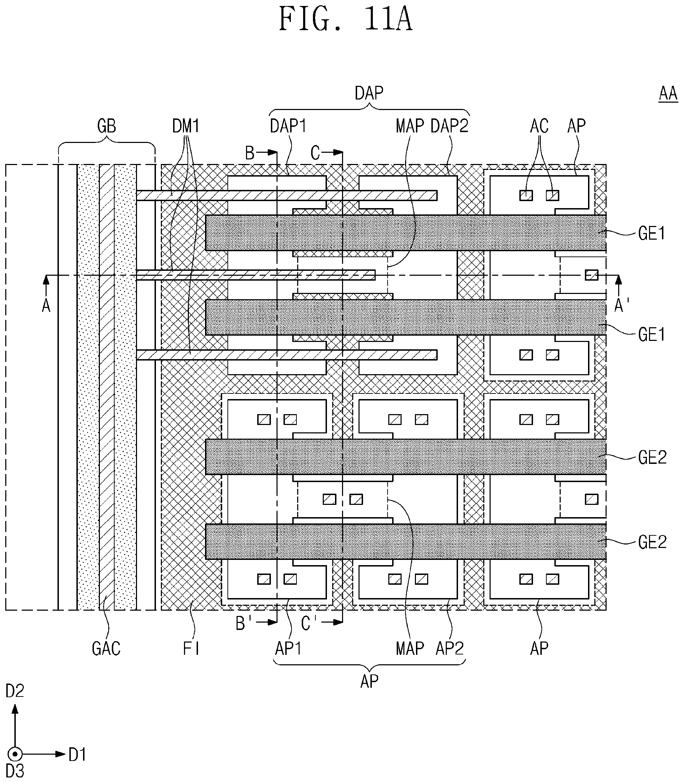

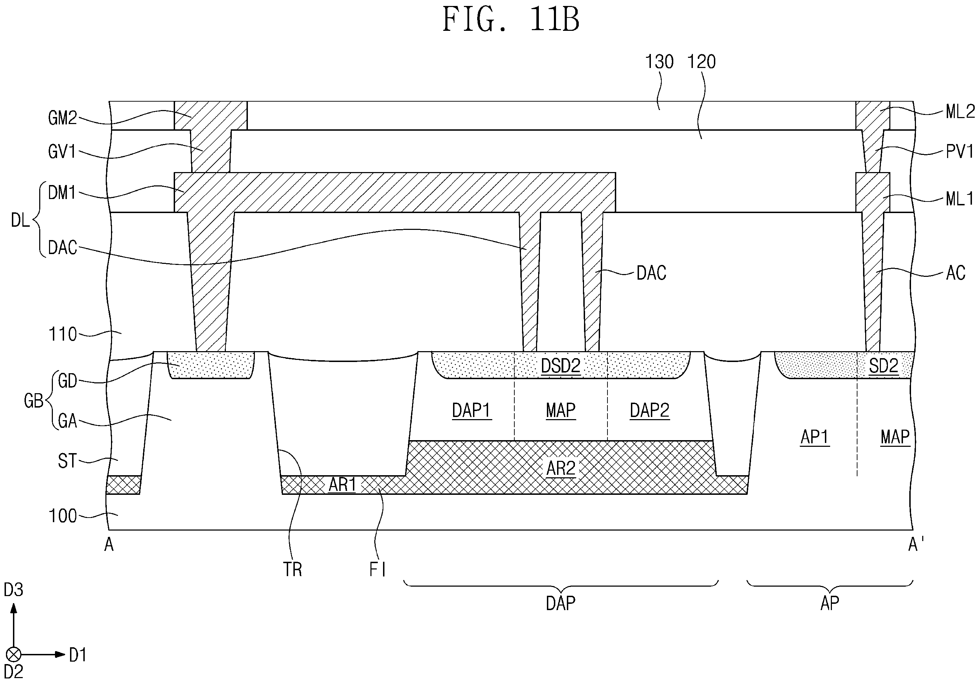

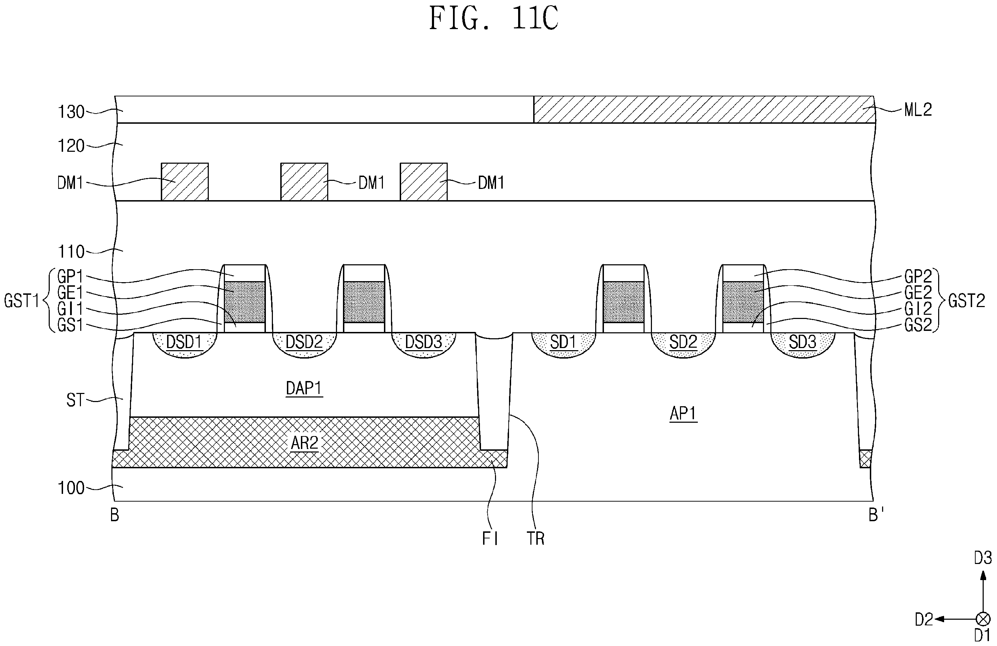

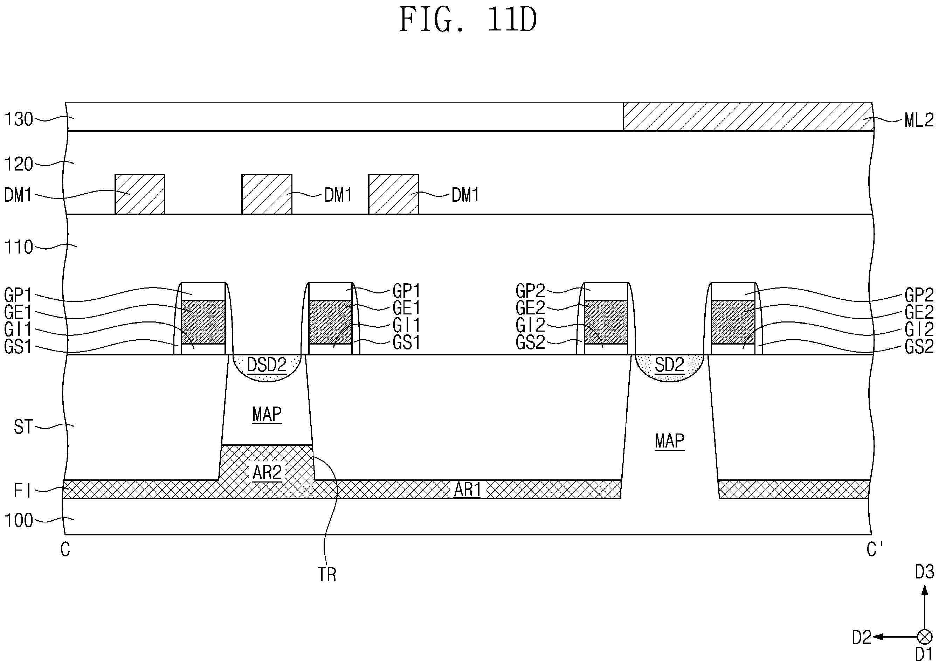

FIG. 11A illustrates an enlarged cross-sectional view of section AA of FIG. 3, showing a semiconductor device according to some embodiments of the present inventive concepts. FIG. 11B illustrates a cross-sectional view taken along line A-A' of FIG. 11A. FIG. 11C illustrates a cross-sectional view taken along line B-B' of FIG. 11A. FIG. 11D illustrates a cross-sectional view taken along line C-C' of FIG. 11A. The following will focus on a difference from the aforementioned semiconductor device according to an embodiment of the present inventive concepts. A detailed explanation of components identical or similar to those discussed above will be omitted in the interest of brevity of description.

Referring to FIGS. 11A to 11D, the field doping region FI may not overlap any of the guard band active pattern GA and the active patterns AP, but may overlap the first and second dummy active patterns DAP1 and DAP2 and the intermediate active patterns MAP. The field doping region FI may include a first region AR1 that does not overlap any of the guard band active pattern GA, the first and second dummy active patterns DAP1 and DAP2, the intermediate active patterns MAP, and the active patterns AP, and may also include a second region AR2 that overlaps the first and second dummy active patterns DAP1 and DAP2 and the intermediate active patterns MAP. For example, the first region AR1 may overlap the device isolation layer ST. When viewed in the third direction D3, the second region AR2 may be thicker than the first region AR1.

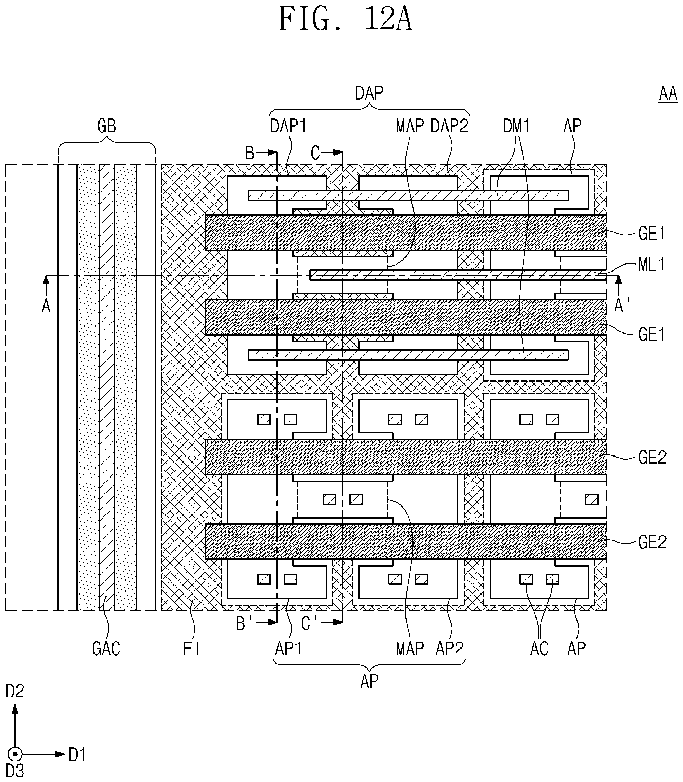

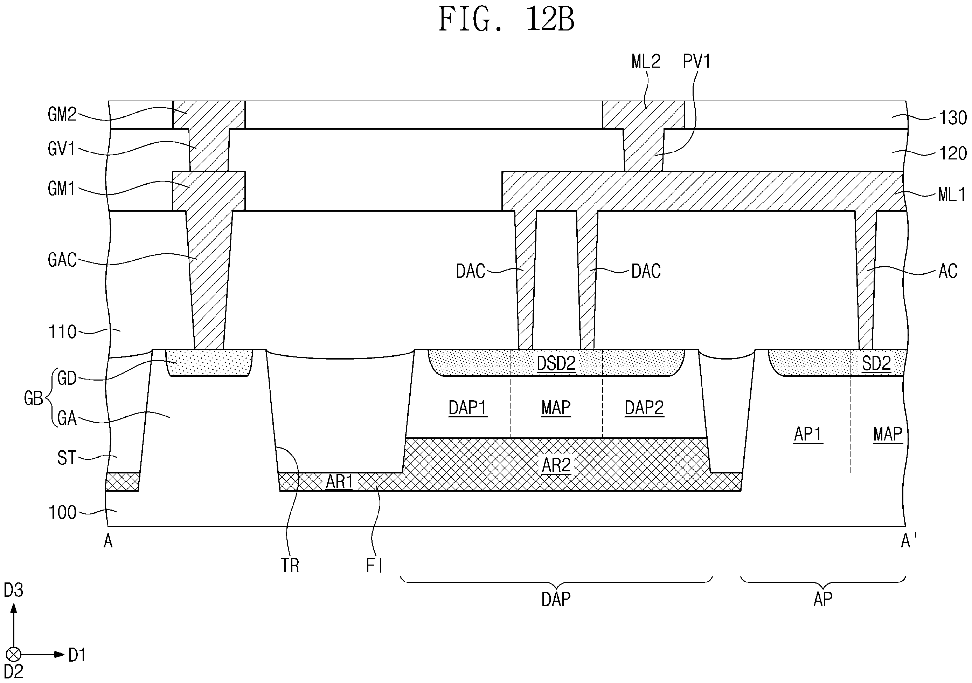

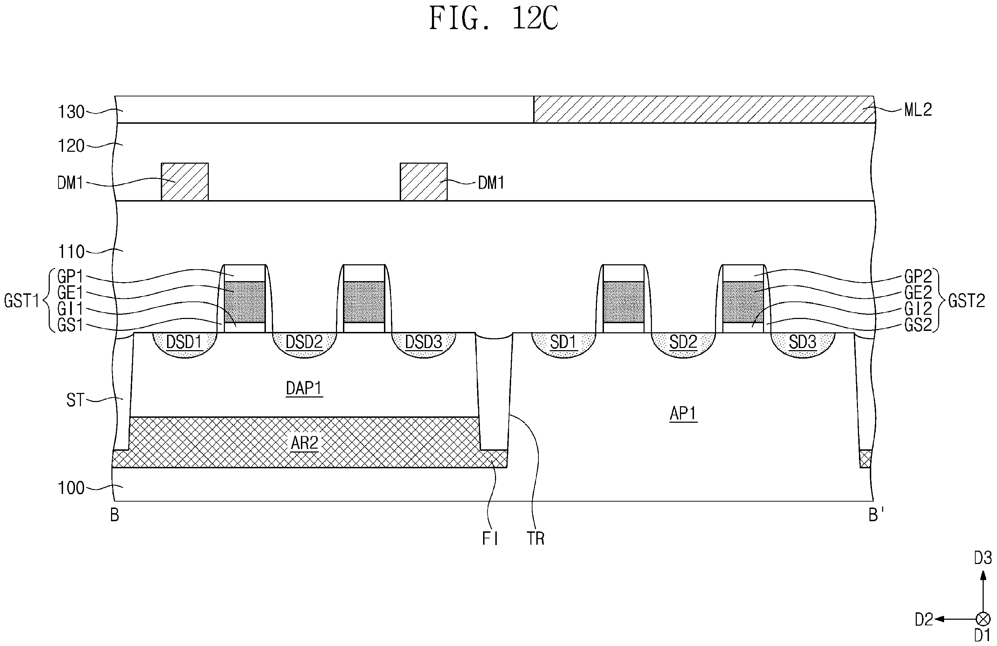

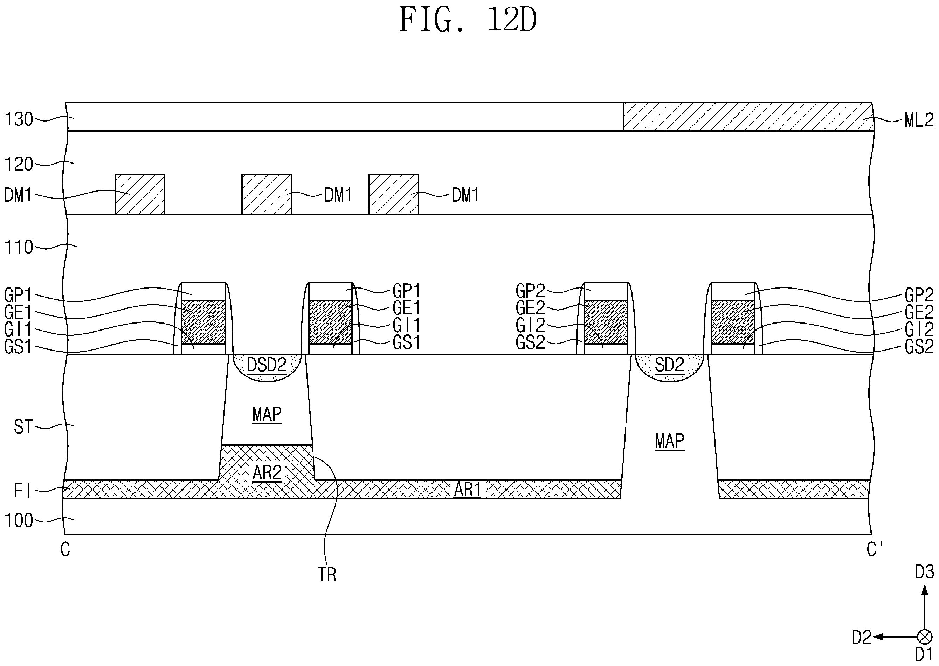

FIG. 12A illustrates an enlarged cross-sectional view of section AA of FIG. 3, showing a semiconductor device according to some embodiments of the present inventive concepts. FIG. 12B illustrates a cross-sectional view taken along line A-A' of FIG. 12A. FIG. 12C illustrates a cross-sectional view taken along line B-B' of FIG. 12A. FIG. 12D illustrates a cross-sectional view taken along line C-C' of FIG. 12A. The following will focus on a difference from the aforementioned semiconductor device according to an embodiment of the present inventive concepts. A detailed explanation of components identical or similar to those discussed above will be omitted in the interest of brevity of description.

Referring to FIGS. 12A to 12D, differently from the embodiments above, the first, second, and third dummy source/drain regions DSD1, DSD2, and DSD3 may have the second conductivity type (e.g., n-type).

The second interlayer dielectric layer 120 may be provided therein with a first guard metal line GM1, first dummy metal lines DM1, first metal lines ML1, first guard vias GV1, and first vias PV1. The first metal lines MI,1 may parallel extend in the first direction D1, and the first guard metal line GM1 may extend in the second direction D2.

Differently from the embodiments above, the first metal lines MI,1 may electrically connect a pair of neighboring dummy active contacts DAC to the active contact AC. For example, the first metal lines MI,1 may electrically connect a pair of neighboring second source/drain regions SD2 to each other. The first dummy metal line DM1 may electrically connect a pair of dummy active contacts DAC adjacent in the first direction D1 to the active contact AC. For example, the first dummy metal line DM1 may electrically connect the first dummy source/drain regions DSD1 to the first source/drain region SD1. The first dummy metal line DM1 may electrically connect the third dummy source/drain regions DSD3 to the third source/drain region SD3. Thus, the dummy transistor on the dummy active pattern DAP may not be in a floating state. The first guard via GV1 may connect the first guard metal line GM1 to the second guard metal line GM2. The first vias PV1 may connect the first metal lines ML1 to the second metal lines ML2.

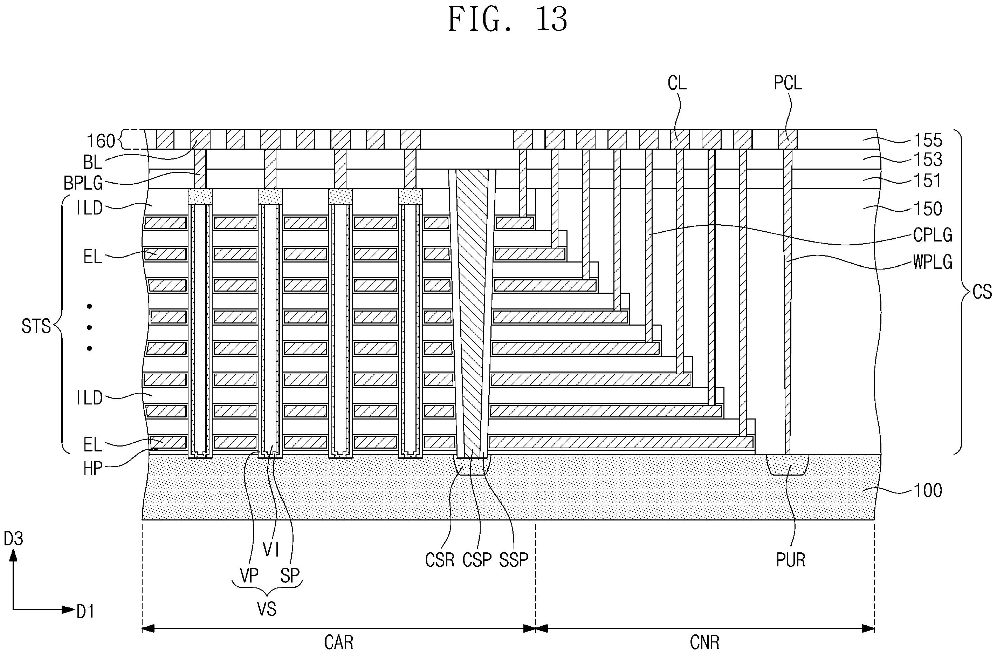

FIG. 13 illustrates a cross-sectional view partially showing a memory cell array of a semiconductor device according to some embodiments of the present inventive concepts. The following will focus on a difference from the aforementioned semiconductor device according to an embodiment of the present inventive concepts. A detailed explanation of components identical or similar to those discussed above will be omitted in the interest of brevity of description.

Referring to FIG. 13, a cell array structure CS may be provided on a substrate 100. The cell array structure CS may include stack structures STS, vertical structures VS, and connection line structures CPLG, CL, WPLG, and PCL. On the substrate 100, the stack structures STS may parallel extend in a first direction D1 and may be arranged spaced apart from each other in a second direction D2. Each of the stack structures STS may include electrodes EL vertically stacked on the substrate 100 and may also include dielectric layers ILD interposed between the electrodes EL. The dielectric layers ILD of the stack structures STS may have their thicknesses that can be changed depending on properties of a semiconductor device. For example, one or more of the dielectric layers ILD may be formed thicker than other ones of the dielectric layers ILD. The dielectric layers ILD may include silicon oxide (SiO). The electrodes EL may include a conductive material including, for example, a semiconductor layer, a metal silicon layer, a metal layer, a metal nitride layer, or a multiple layer including a combination thereof.

The stack structures STS may extend along the first direction D1 from a cell array region CAR toward a connection region CNR, and may have a stepwise structure on the connection region CNR. The electrodes EL of the stack structures STS may have lengths in the first direction D1 that decrease with increasing distance from the substrate 100. The stack structures STS may have variously shaped stepwise structures on the connection region CNR.

In some embodiments, a semiconductor device may be a three-dimensional NAND Flash memory device, and memory cell strings (see CSTR of FIG. 1A) may be integrated on the substrate 100. In this case, the stack structures STS may be configured such that uppermost and lowermost electrodes EL may be used as gate electrodes of string and ground selection transistors. For example, the topmost electrode EL may serve as a gate electrode of a string selection transistor that controls an electrical connection between a bit line BL and the vertical structures VS, and the bottommost electrode EL may serve as a gate electrode of a ground selection transistor that controls an electrical connection between a common source line (see CSL of FIG. 1A) and the vertical structures VS. Other electrodes EL between the uppermost and lowermost electrodes EL may serve as control gate electrodes of memory cells and as word lines (see WL of FIG. 1A) that connect the control gate electrodes to each other.

On the cell array region CAR, the vertical structures VS may penetrate the stack structures STS to come into contact with the substrate 100. The vertical structures VS may be electrically connected to the substrate 100. When viewed in plan, the vertical structures VS may be arranged in a straight or zigzag fashion along one direction. On the connection region CNR, dummy vertical structures (not shown) may be provided which have substantially the same structures as those of the vertical structures VS.

The vertical structures VS may include a semiconductor material, such as silicon (Si), germanium (Ge), or a mixture thereof. Additionally or alternatively, the vertical structures VS may include an impurity-doped semiconductor or an impurity-undoped intrinsic semiconductor. The vertical structures VS including a semiconductor material may be used as channels of the string and ground selection transistors and the memory cells. The vertical structures VS may have bottom surfaces between top and bottom surfaces of the substrate 100. The vertical structures VS may each be provided on its upper end with a contact pad coupled to a bit-line contact plug BPLG.

Each of the vertical structures VS may include a vertical dielectric pattern VP and a semiconductor pattern SP in contact with the substrate 100. The semiconductor pattern SP may have a hollow pipe shape or a macaroni shape. The semiconductor pattern SP may have a shape whose bottom end is closed, and a buried dielectric pattern VI may fill an inside of the semiconductor pattern SP. The semiconductor pattern SP may be in contact with a top surface of the substrate 100. The semiconductor pattern SP may be undoped or doped with an impurity whose conductivity type is the same as that of the substrate 100. The semiconductor pattern SP may be polycrystalline or monocrystalline.

A vertical dielectric pattern VP may be disposed between the stack structure STS and the vertical structures VS. The vertical dielectric pattern VP may extend in a third direction D3 and may surround a sidewall of the vertical structure VS. For example, the vertical dielectric pattern VP may have a macaroni shape or a pipe shape whose top and bottom ends are opened.

The vertical dielectric pattern VP may be formed of a single thin layer or a plurality of thin layers. In some embodiments of the present inventive concepts, the vertical dielectric pattern VP may be a portion of a data storage layer. For example, the vertical dielectric pattern VP may include a tunnel dielectric layer, a charge storage layer, and a blocking dielectric layer, which layers constitute a data storage layer of a semiconductor device such as a NAND Flash memory device. For example, the charge storage layer may be a trap dielectric layer, a floating gate electrode, or a dielectric layer including conductive nano-dots. For example, the charge storage layer may include at least one selected from silicon nitride (SiN), silicon oxynitride (SiON), silicon-rich nitride, nano-crystalline silicon, and laminated trap layer. The tunnel dielectric layer may be one of materials whose band gap is greater than that of the charge storage layer, and the blocking dielectric layer may be a high-k dielectric layer such as aluminum oxide (Al₂O₃) and hafnium oxide (Hf₂O). Alternatively, the vertical dielectric pattern VP may include a thin layer either for a phase change memory device or for a variable resistance memory device.

A horizontal dielectric pattern HP may be provided between the vertical dielectric pattern VP and sidewalls of the electrodes EL. The horizontal dielectric pattern HP may extend onto top and bottom surfaces of the electrodes EL from the sidewalls of the electrodes EL. The horizontal dielectric pattern HP may include a charge storage layer and a tunnel dielectric layer that serve as a component of a data storage layer of a NAND Flash memory device. Alternatively, the horizontal dielectric pattern HP may include a blocking dielectric layer.

The substrate 100 may be provided therein with common source regions CSR between the electrode structures ST adjacent to each other. The common source regions CSR may extend in the first direction D1 parallel to the stack structures STS. The common source regions CSR may be formed by doping the substrate 100 with impurities of a second conductivity type. The common source regions CSR may include, for example, n-type impurities (e.g., arsenic (As) or phosphorus (P)).

A common source plug CSP may be coupled to the common source region CSR. A sidewall dielectric spacer SSP may be interposed between the common source plug CSP and the stack structures STS. In a read or program mode of a semiconductor device such as a three-dimensional NAND Flash memory device, a ground voltage may be applied through the common source plug CSP to the common source region CSR.

A first buried dielectric layer 150 may be disposed on the substrate 100, while covering stepwise ends of the electrodes EL. A first dielectric layer 151 may cover top surfaces of the vertical structures VS and may be provided thereon with a second dielectric layer 153 that covers a top surface of the common source plug CSP.

Bit lines BL may be provided on the second dielectric layer 153 and may extend lengthwise in the second direction D2 to thereby run across the stack structures STS. Each of the bit lines BL may be electrically connected through the bit-line contact plug BPLG to the vertical structure VS.

The stepwise ends of the stack structures ST may be provided thereon with a connection line structure that electrically connects the cell array structure CS to a peripheral logic structure (not shown). The peripheral circuit structure may be provided in the substrate 100 or between the cell array structure CS and the substrate 100. The connection line structure may include cell contact plugs CPLG that penetrate the first and second dielectric layers 151 and 153 and the first buried dielectric layer 150 to come into connection with corresponding ends of the electrodes EL, and may also include connection lines CL that are provided on the second dielectric layer 153 to come into connection with corresponding cell contact plugs CPLG. In addition, the connection line structure may include well contact plugs WPLG coupled to well pick-up regions PUR in the substrate 100, and may also include peripheral connection lines PCL connected to the well contact plugs WPLG.

In the substrate 100, the well pick-up regions PUR may be disposed adjacent to opposite ends of each of the stack structures STS. The well pick-up regions PUR may have the same conductivity type as that of the substrate 100, and may have an impurity concentration greater than that of the substrate 100. According to some embodiments, in an erase operation of a semiconductor device such as a three-dimensional NAND Flash memory device, an erase voltage may be applied to the well pick-up regions PUR through the well contact plugs WPLG.

The second dielectric layer 153 may be provided thereon with a third dielectric layer 155 that surrounds the bit lines BL, the connection lines CL, and the peripheral connection lines PCL. The third dielectric layer 155 may expose top surface of the bit lines BL, top surfaces of the connection lines CL, and top surfaces of the peripheral connection lines PCL. The bit lines BL, the connection lines CL, and the peripheral connection lines PCL may constitute a cell array wiring layer 160.

According to some embodiments of the present inventive concepts, when a semiconductor device is operated, a depletion region of a dummy transistor and a depletion region of a pass transistor may not overlap each other to reduce distribution of breakdown voltage and threshold voltage of the pass transistor. Accordingly, a semiconductor device may increase in reliability.

Embodiments are set out in the following clauses:
Clause 1. A semiconductor device, comprising: a substrate having at least one device isolation layer embedded therein, which defines a dummy active pattern and a plurality of active patterns within the substrate; a guard band extending within the substrate and surrounding the dummy active pattern and the plurality of active patterns; a dummy transistor having a plurality of dummy source/drain regions within the dummy active pattern; a plurality of pass transistors having source/drain regions within the plurality of active patterns; a plurality of dummy wiring lines that electrically connect the guard band to the dummy source/drain regions of the dummy transistor; and a field doping region at least partially overlapping with the device isolation layer, said field doping region having an impurity therein that extends into the substrate.
Clause 2. The device of clause 1, wherein the guard band includes a guard doping region of first conductivity type therein; and wherein the dummy source/drain regions are doped with an impurity of the first conductivity type.
Clause 3. The device of clause 1 or 2, wherein the source/drain regions within the plurality of active patterns are doped with an impurity of second conductivity type.
Clause 4. The device of any preceding clause, wherein the guard band includes a guard doping region of first conductivity type therein; and wherein the field doping region is doped with an impurity of the first conductivity type.
Clause 5. The device of any preceding clause, wherein a portion of the field doping region overlaps the dummy active pattern.
Clause 6. The device of any preceding clause, further comprising: a plurality of guard active contacts; wherein the guard band includes a guard doping region of first conductivity type therein, which is electrically coupled to the plurality of guard active contacts; and wherein the plurality of dummy wiring lines are electrically connected to the guard active contacts.
Clause 7. The device of any preceding clause, further comprising: a memory cell structure including a plurality of conductive patterns and a plurality of dielectric layers that are vertically alternately stacked on the substrate; and wherein the plurality of pass transistors are electrically connected to the plurality of conductive patterns.
Clause 8. The device of any preceding clause, further comprising: a plurality of gate electrodes on the plurality of active patterns; and wherein each of the plurality of gate electrodes extends onto the dummy active pattern between the plurality of dummy source/drain regions.
Clause 9. The device of any preceding clause, wherein the dummy transistor and the pass transistors share first and second gate electrodes, which run across the dummy active pattern and the active patterns; wherein the dummy source/drain regions include first, second, and third dummy source/drain regions; wherein the first gate electrode extends between the first and second dummy source/drain regions; and wherein the second gate electrode extends between the second and third dummy source/drain regions.
Clause 10. The device of any preceding clause, wherein the substrate includes an intermediate active pattern, which electrically connects the dummy active pattern to the active pattern near the dummy active pattern; wherein the dummy transistor and the pass transistors share first and second gate electrodes that run across the dummy active pattern and the active patterns; and wherein the intermediate active pattern extends between the first and second gate electrodes.
Clause 11. The device of any preceding clause, wherein the dummy active pattern includes a first dummy active pattern, a second dummy active pattern, and an intermediate active pattern; wherein the second dummy active pattern is spaced apart in a first direction from the first dummy active pattern, the first direction being parallel to the substrate; wherein the intermediate active pattern electrically connects the first dummy active pattern to the second dummy active pattern; wherein the dummy transistor includes first and second gate electrodes that run across the first dummy active pattern and the second dummy active pattern; and wherein the intermediate active pattern is between the first and second gate electrodes.
Clause 12. The device of clause 11, wherein the dummy wiring lines electrically connect the intermediate active pattern to the guard band.
Clause 13. The device of any preceding clause, wherein the substrate includes an intermediate active pattern that connects the dummy active pattern to the active pattern near the dummy active pattern; wherein the dummy transistor and the pass transistors share first and second gate electrodes that run across the dummy active pattern and the active patterns; wherein the intermediate active pattern extends between the first and second gate electrodes; and wherein a portion of the field doping region overlaps the dummy active pattern.
Clause 14. The device of any preceding clause, wherein the dummy active pattern includes a first dummy active pattern, a second dummy active pattern, and an intermediate active pattern;
wherein the second dummy active pattern is spaced apart in a first direction from the first dummy active pattern, the first direction being parallel to the substrate; wherein the intermediate active pattern electrically connects the first dummy active pattern to the second dummy active pattern; wherein the dummy transistor includes first and second gate electrodes that run across the first dummy active pattern and the second dummy active pattern; wherein the intermediate active pattern extends between the first and second gate electrodes; and wherein a portion of the field doping region overlaps the dummy active pattern.
Clause 15. The device of any preceding clause, wherein the field doping region includes a first region that overlaps the device isolation layer and a second region that overlaps the dummy active pattern; and wherein a top surface of the second region is at a level higher than a level of a top surface of the first region.
Clause 16. The device of any preceding clause, wherein the field doping region includes at least one of B and BF2.
Clause 17. The device of any preceding clause, further comprising a decoder, which extends on the substrate and is electrically connected to the pass transistors.
Clause 18. A semiconductor device, comprising: a dummy active pattern, a guard band active pattern, and a plurality of active patterns on a substrate; a device isolation layer that defines the dummy active pattern, the guard band active pattern, and the active patterns; a plurality of pass transistors on the active patterns; a field doping region in the substrate and doped with an impurity, the field doping region overlapping the device isolation layer; a plurality of dummy source/drain regions on the dummy active pattern, the dummy source/drain regions having a first conductivity type; a guard doping region on the guard band active pattern, the guard doping region having the first conductivity type impurity therein; a plurality of gate electrodes on the dummy active pattern between the dummy source/drain regions, each of the gate electrodes extending onto the active patterns; an interlayer dielectric layer that covers the gate electrodes, the dummy source/drain regions, the pass transistors, and the guard doping region; a plurality of dummy active contacts that penetrate the interlayer dielectric layer to come into connection with the dummy source/drain regions; a guard active contact that penetrates the interlayer dielectric layer to come into connection with the guard doping region; and a plurality of dummy metal lines that connect the dummy active contacts to the guard active contact.
Clause 19. The device of clause 18, wherein a portion of the field doping region overlaps the dummy active pattern.
Clause 20. An electronic system, comprising: a semiconductor device that includes an input/output pad electrically connected to a peripheral circuit; and a controller which controls the semiconductor device and is electrically connected through the input/output pad to the semiconductor device; wherein the semiconductor device includes: a device isolation layer extending within a substrate and defining a dummy active pattern and a plurality of active patterns; a guard band extending within the substrate and surrounding the dummy active pattern and the active patterns; a dummy transistor on the dummy active pattern and including a plurality of dummy source/drain regions; a plurality of pass transistors on the active patterns; a plurality of dummy wiring lines that electrically connect the guard band to the dummy source/drain regions of the dummy transistor; and a field doping region that includes a doped impurity in the substrate and overlaps the device isolation layer.

Although the present invention has been described in connection with some embodiments of the present inventive concepts illustrated in the accompanying drawings, it will be understood to those skilled in the art that various changes and modifications may be made without departing from the present inventive concepts. It will be apparent to those skilled in the art that various substitution, modifications, and changes may be thereto without departing from the scope of the present inventive concepts.

## Claims

1. A semiconductor device, comprising:
a substrate having at least one device isolation layer embedded therein, which defines a dummy active pattern and a plurality of active patterns in the substrate;
a guard band extending in the substrate and surrounding the dummy active pattern and the plurality of active patterns;
a dummy transistor having a plurality of dummy source/drain regions in the dummy active pattern;
a plurality of pass transistors having source/drain regions in the plurality of active patterns;
a plurality of dummy wiring lines that electrically connect the guard band to the dummy source/drain regions of the dummy transistor; and
a field doping region at least partially overlapping with the device isolation layer, wherein said field doping region includes a doped impurity in the substrate.

2. The device of Claim 1, wherein the guard band includes a guard doping region of first conductivity type therein; and wherein the dummy source/drain regions are doped with an impurity of the first conductivity type.

3. The device of Claim 1 or 2, wherein the source/drain regions in the plurality of active patterns are doped with an impurity of second conductivity type.

4. The device of any preceding claim, wherein the guard band includes a guard doping region of first conductivity type therein; and wherein the field doping region is doped with an impurity of the first conductivity type.

5. The device of any preceding claim, wherein a portion of the field doping region overlaps the dummy active pattern.

6. The device of any preceding claim, further comprising:
a plurality of guard active contacts;
wherein the guard band includes a guard doping region of first conductivity type therein, which is electrically coupled to the plurality of guard active contacts; and
wherein the plurality of dummy wiring lines are electrically connected to the guard active contacts.

7. The device of any preceding claim, further comprising:
a memory cell structure including a plurality of conductive patterns and a plurality of dielectric layers that are vertically alternately stacked on the substrate; and
wherein the plurality of pass transistors are electrically connected to the plurality of conductive patterns.

8. The device of any preceding claim, further comprising:
a plurality of gate electrodes on the plurality of active patterns; and
wherein each of the plurality of gate electrodes extends onto the dummy active pattern between the plurality of dummy source/drain regions.

9. The device of any preceding claim,
wherein the dummy transistor and the pass transistors share first and second gate electrodes, which run across the dummy active pattern and the active patterns;
wherein the dummy source/drain regions include first, second, and third dummy source/drain regions;
wherein the first gate electrode extends between the first and second dummy source/drain regions; and
wherein the second gate electrode extends between the second and third dummy source/drain regions.

10. The device of any preceding claim,
wherein the substrate includes an intermediate active pattern, which electrically connects the dummy active pattern to the active pattern near the dummy active pattern;
wherein the dummy transistor and the pass transistors share first and second gate electrodes that run across the dummy active pattern and the active patterns; and
wherein the intermediate active pattern extends between the first and second gate electrodes.

11. The device of any preceding claim,
wherein the dummy active pattern includes a first dummy active pattern, a second dummy active pattern, and an intermediate active pattern;
wherein the second dummy active pattern is spaced apart in a first direction from the first dummy active pattern, the first direction being parallel to the substrate;
wherein the intermediate active pattern electrically connects the first dummy active pattern to the second dummy active pattern;
wherein the dummy transistor includes first and second gate electrodes that run across the first dummy active pattern and the second dummy active pattern; and
wherein the intermediate active pattern is between the first and second gate electrodes.

12. The device of Claim 11, wherein the dummy wiring lines electrically connect the intermediate active pattern to the guard band.

13. The device of any preceding claim,
wherein the substrate includes an intermediate active pattern that connects the dummy active pattern to the active pattern near the dummy active pattern;
wherein the dummy transistor and the pass transistors share first and second gate electrodes that run across the dummy active pattern and the active patterns;
wherein the intermediate active pattern extends between the first and second gate electrodes; and
wherein a portion of the field doping region overlaps the dummy active pattern.

14. The device of any preceding claim,
wherein the dummy active pattern includes a first dummy active pattern, a second dummy active pattern, and an intermediate active pattern;
wherein the second dummy active pattern is spaced apart in a first direction from the first dummy active pattern, the first direction being parallel to the substrate;
wherein the intermediate active pattern electrically connects the first dummy active pattern to the second dummy active pattern;
wherein the dummy transistor includes first and second gate electrodes that run across the first dummy active pattern and the second dummy active pattern;
wherein the intermediate active pattern extends between the first and second gate electrodes; and
wherein a portion of the field doping region overlaps the dummy active pattern.

15. The device of any preceding claim, wherein the field doping region includes a first region that overlaps the device isolation layer and a second region that overlaps the dummy active pattern; and wherein a top surface of the second region is at a level higher than a level of a top surface of the first region.
